# EUROPEAN PATENT SPECIFICATION

(11) **EP 3 883 001 B1**
(45) Date of publication and mention of the grant of the patent: **24.01.2024**
(21) Application number: 21153366.6
(22) Date of filing: 26.01.2021
(51) Int. Cl.: H10K 50/842, H10K 59/80, H10K 59/12

(54) **DISPLAY DEVICE**
ANZEIGEVORRICHTUNG
DISPOSITIF D'AFFICHAGE

(30) Priority: 17.03.2020 KR 20200032370
(43) Date of publication of application: 22.09.2021
(73) Proprietor: Samsung Display Co., Ltd., Yongin-si, Gyeonggi-Do 17113 (KR)
(72) Inventor: PARK, June Hyoung, Seoul 112-204 (KR); KO, Kyung Rok, Gyeonggi-do 106-3505 (KR); KIM, Byung Hoon, Gyeonggi-do (KR); KIM, Jung Hyun, Gyeonggi-do 102-602 (KR); KIM, Tae Oh, Gyeonggi-do 105-1401 (KR)
(74) Representative: Dr. Weitzel & Partner

(56) References cited:
- EP-A1- 2 549 461
- US-A1- 2015 001 487
- US-A1- 2015 144 917

## Description

### BACKGROUND

### 1. Field

The present disclosure relates to a display device.

### 2. Description of the Related Art

A display device becomes increasingly important with the development of multimedia. Accordingly, various types of display devices such as organic light emitting displays and liquid crystal displays are being used.

The display device is a device for displaying an image and includes a display panel such as an organic light emitting display panel or a liquid crystal display panel. As a light emitting display panel, the display panel may include light emitting elements such as light emitting diodes ("LEDs"). For example, the LEDs may be organic light emitting diodes ("OLEDs") using an organic material as a fluorescent material or may be inorganic LEDs using an inorganic material as the fluorescent material.

US 2015/144917 A1 discloses a display device comprising a first seal surrounding a display area and a second seal in the display area to improve mechanical strength of the display device.

EP2549461 A1 discloses a display device comprising a sealing member made of frit and treated with laser light.

US 2015/001487 A1 discloses a display device comprising a frit sealant.

### SUMMARY

Aspects of the present disclosure provide a display device having improved adhesion between a display panel and an encapsulation substrate.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an embodiment of the present disclosure, a display device includes a display panel including a display area in which a plurality of light emitting elements are disposed and a non-display area which surrounds the display area, an encapsulation substrate which is disposed on the display panel at a distance from the display panel, a sealing member which is disposed in the non-display area between the display panel and the encapsulation substrate to bond the display panel and the encapsulation substrate together, a plurality of support members which are disposed in the display area between the display panel and the encapsulation substrate, and a first fusion pattern, at least a portion of which is disposed in each of the support members and the encapsulation substrate, where the display area includes a first area in which the support member and the first fusion pattern are disposed and a second area in which the support member is not disposed, and each of the light emitting elements is disposed in the second area.

The display panel includes a plurality of pixels disposed in the display area, and some of the pixels include the light emitting elements, and the support members is disposed not to overlap the light emitting elements in a plan view.

The pixels include first type pixels in which the support members are disposed and second type pixels in which the support member is not disposed but the light emitting element is included.

In an example, not forming part of the claimed invention, each of the pixels may include an emission area in which the light emitting element is disposed and a non-emission area in which no light emitting element is disposed but the support member is disposed.

The display panel further includes a base substrate, and the support members directly contact an upper surface of the base substrate and a lower surface of the encapsulation substrate.

The first fusion pattern may extend from the encapsulation substrate to the base substrate such that at least a portion of the first fusion pattern is disposed in the base substrate.

The first fusion pattern includes materials of the support member, the encapsulation substrate and may include material of the base substrate.

The first fusion pattern may include a fusion area in which the base substrate, a support member and the encapsulation substrate are partially fused and a molten area which surrounds the fusion area.

The first fusion pattern may include a portion that becomes wider along a direction from the base substrate toward the encapsulation substrate.

Each of the support members may include a first boundary surface contacting the base substrate and a second boundary surface contacting the encapsulation substrate, and no physical boundary may exist in a virtual extension line in the first fusion pattern, the virtual extension line extending from each of the first boundary surface and the second boundary surface.

The first fusion pattern may include a first portion disposed in the display panel, a second portion disposed in the sealing member, a third portion disposed in the encapsulation substrate, a third boundary surface between the second portion and the sealing member, a fourth boundary surface between the first portion and the display panel and a fifth boundary surface between the third portion and the encapsulation substrate.

The first fusion pattern may have a different refractive index from the support members.

The display device may further include a second fusion pattern, at least a portion of which is disposed in the sealing member and the encapsulation substrate.

The sealing member and the second fusion pattern may be disposed in the non-display area to surround the display area.

According to the claimed invention, a display device is as recited in claim 1.

The first type pixel may not include the light emitting elements, and the support members may directly contact an upper surface of the base substrate and a lower surface of the encapsulation substrate.

Each of the support members may include a first boundary surface contacting the base substrate and a second boundary surface contacting the encapsulation substrate, and no physical boundary may exist in a virtual extension line in the first fusion pattern, the virtual extension line extending from each of the first boundary surface and the second boundary surface.

The second type pixels may include a first subpixel which emits light of a first color and a second subpixel which emits light of a second color different from the first color.

The display panel includes a display area in which the pixels are disposed and a non-display area which surrounds the display area, and may further includes a sealing member which is disposed in the non-display area to surround the display area and bonds the encapsulation substrate and the display panel together.

The display device may further include a second fusion pattern which is disposed over the support member, the base substrate and the encapsulation substrate, where the second fusion pattern surrounds the display area to have a closed curve shape.

### BRIEF DESCRIPTION OF THE DRAWINGS

These and/or other aspects will become apparent and more readily appreciated from the following description of the embodiments, taken in conjunction with the accompanying drawings in which:
FIG. 1 is a schematic perspective view of a display device according to an embodiment;
FIG. 2 is a plan view of the display device according to the embodiment;
FIG. 3 is a schematic cross-sectional view of the display device according to the embodiment;
FIG. 4 is a schematic plan view of a display panel according to an embodiment;
FIG. 5 is a cross-sectional view of a pixel included in the display device according to the embodiment;
FIG. 6 is a plan view illustrating a sealing member and support members disposed on the display panel according to the embodiment;
FIG. 7 is an enlarged view of portion A of FIG. 6;
FIG. 8 is a cross-sectional view taken along line VIII-VIII' of FIG. 7;
FIG. 9 is an enlarged view of portion B of FIG. 8;
FIG. 10 is a cross-sectional view taken along line X-X' of FIG. 6;
FIG. 11 is a schematic cross-sectional view illustrating emission of light through the support members included in the display device according to the embodiment;
FIGS. 12 through 14 are cross-sectional views illustrating a process of fabricating a display device according to an embodiment;
FIG. 15 is a cross-sectional view of a portion of a display device according to an embodiment;
FIG. 16 is a cross-sectional view illustrating a second fusion pattern disposed in the display device according to the embodiment of FIG. 15;
FIG. 17 is a plan view of support members disposed on a display panel according to an embodiment not forming part of the claimed invention;
FIG. 18 is an enlarged view of portion C of FIG. 17;
FIG. 19 is an enlarged view of portion D of FIG. 18;
FIG. 20 is a cross-sectional view taken along line E-E' of FIG. 18;
FIG. 21 is a schematic cross-sectional view of a portion of a display device according to an embodiment; and
FIGS. 22 and 23 are schematic cross-sectional views illustrating parts of display devices according to embodiments.

### DETAILED DESCRIPTION

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided such that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below. Hereinafter, embodiments will be described with reference to the accompanying drawings.

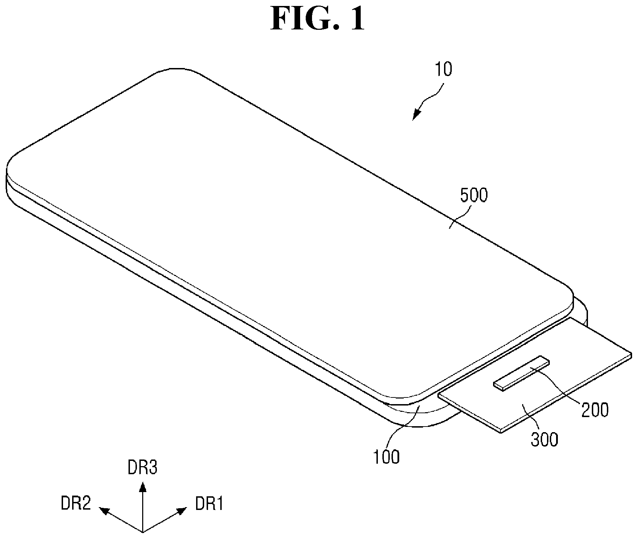

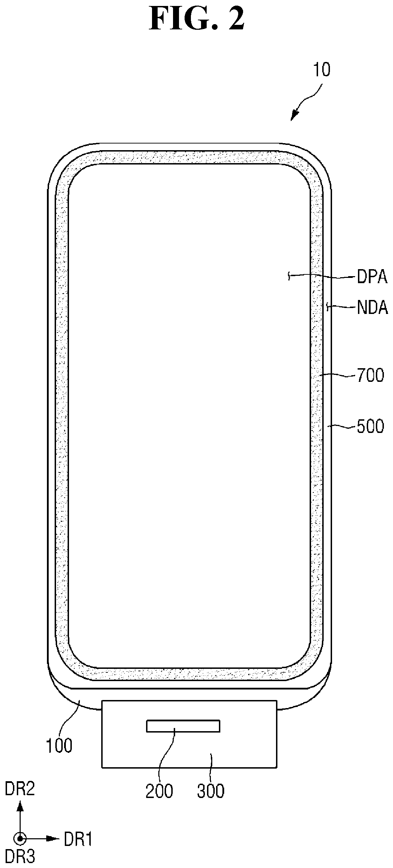

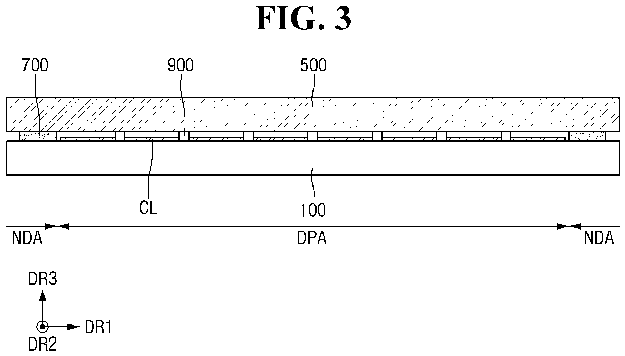

FIG. 1 is a schematic perspective view of a display device 10 according to an embodiment. FIG. 2 is a plan view of the display device 10 according to the embodiment. FIG. 3 is a schematic cross-sectional view of the display device 10 according to the embodiment. FIG. 3 is a cross-section of the display device 10 of FIG. 1, taken along a first direction DR1. In FIG. 3, only a display panel 100, an encapsulation substrate 500, and a sealing member 700 are illustrated.

In the present specification, the first direction DR1 may be a direction parallel to short sides of the display device 10 in a plan view, for example, may be a horizontal direction of the display device 10 as shown in FIG. 1. A second direction DR2 may be a direction parallel to long sides of the display device 10 in a plan view, for example, may be a vertical direction of the display device 10. A third direction DR3 may be a thickness direction of the display device 10. In addition, the first direction DR1 of an object (e.g., the display device 10) may indicate a right side of the object when the object (e.g., the display device 10) is seen in the third direction DR3 (i.e., in a plan view), a direction opposite to the first direction DR1 of the object may be a left side of the object, the second direction DR2 of the object may indicate an upper side of the object in a plan view, a direction opposite to the second direction DR2 of the object may be a lower side of the object, the third direction DR3 of the object may indicate an upward direction or a top of the object, and a direction opposite to the third direction DR3 may be a downward direction or a bottom of the object.

Referring to FIGS. 1 through 3, the display device 10 may be applied to various electronic devices including small and medium-sized electronic devices such as tablet personal computers ("PCs"), smartphones, car navigation units, cameras, center information displays ("CIDs") provided in cars, wristwatch-type electronic devices, personal digital assistants ("PDAs"), portable multimedia players ("PMPs") and game machines and medium and large-sized electronic devices such as televisions, external billboards, monitors, PCs and notebook computers. However, these are just examples, and the display device 10 can also be employed in other electronic devices without departing from the concept of the present disclosure.

The display device 10 may be a light emitting display device such as an organic light emitting display device using organic light emitting diodes, a quantum dot light emitting display device including quantum dot light emitting layers, an inorganic light emitting display device including inorganic semiconductors, or a micro light emitting diode display device using micro light emitting diodes. A case where the display device 10 is an organic light emitting display device will be mainly described below, but the present disclosure according to the invention is not limited thereto.

The display device 10 includes the display panel 100 (i.e., a first substrate), a display driver 200, a display circuit board 300, the encapsulation substrate 500 (i.e., a second substrate), the sealing member 700, and support members 900.

The display panel 100 may be shaped like a rectangular plane having short sides in the first direction DR1 and long sides in the second direction DR2 intersecting the first direction DR1. Each corner where a short side extending in the first direction DR1 meets a long side extending in the second direction DR2 may be rounded or right-angled. The planar shape of the display panel 100 according to the invention is not limited to the quadrangular shape, but may also be another polygonal shape, a circular shape, or an oval shape in another embodiment.

The display panel 100 may be flat, but the present disclosure according to the invention is not limited thereto. For example, in another embodiment, the display panel 100 may also include a curved portion at its left and right ends and having a constant or varying curvature. In addition, the display panel 100 may be flexible such that it can be curved, bent, folded, or rolled.

The display panel 100 includes a display area DPA and a non-display area NDA. The display area DPA may be an area where a screen can be displayed, and the non-display area NDA may be an area where no screen is displayed. The display area DPA may be referred to as an active area, and the non-display area NDA may also be referred to as an inactive area. The display area DPA may generally occupy a center of the display panel 100.

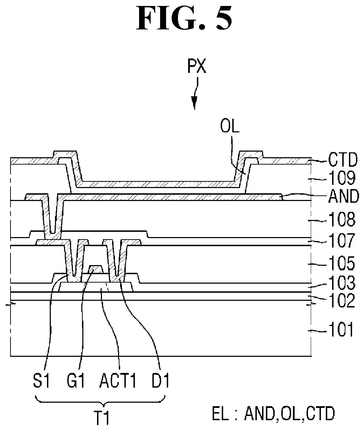

The display area DPA includes a plurality of pixels PX. The pixels PX may be arranged in a matrix from in a plan view. Each of the pixels PX may be rectangular or square in a plan view. However, the present disclosure according to the invention is not limited thereto, and each of the pixels PX may also have a rhombic planar shape having each side inclined with respect to a horizontal direction in another embodiment. The pixels PX may be alternately arranged in a stripe or pentile type. In addition, in an example not forming part of the claimed invention, each of the pixels PX may include one or more light emitting elements EL (see FIG. 5) that emit light of a specific wavelength band to display a specific color. However, including the light emitting elements is not a mandatory requirement for a pixel PX in the present claimed invention. (See FIS. 7 and 8 and the description thereof.)

The non-display area NDA may be disposed around the display area DPA. The non-display area NDA may entirely or partially surround the display area DPA. The display area DPA may be rectangular, and the non-display area NDA may be disposed adjacent to four sides of the display area DPA. The non-display area NDA may form a bezel of the display panel 100. In the non-display areas NDA, wirings or circuit drivers included in the display panel 100 or external devices may be disposed.

The display driver 200 outputs signals and voltages for driving the display panel 100. For example, the display driver 200 may supply data voltages to data wirings. In addition, the display driver 200 may supply driving voltages to driving voltage wirings and supply scan control signals to a scan driver. The display driver 200 may be formed as an integrated circuit ("IC") and attached onto the display circuit board 300. Alternatively, the display driver 200 may be attached to the display panel 100 using a chip-on-glass ("COG") method, a chip-on-plastic ("COP") method, or an ultrasonic bonding method.

The display circuit board 300 may be disposed in the non-display area NDA at an edge of the display panel 100. For example, the display circuit board 300 may be disposed in the non-display area NDA at a lower edge of the display panel 100 as shown in FIG. 2. The display circuit board 300 may be bent toward a lower surface of the display panel 100, and an edge of the display circuit board 300 disposed on the lower surface of the display panel 100 may be attached to the lower surface of the display panel 100. Although not illustrated in the drawings, the display circuit board 300 may be attached and fixed to the lower surface of the display panel 100 through an adhesive member. The adhesive member may be a pressure-sensitive adhesive. Alternatively, the display circuit board 300 may be omitted, and an edge of the display panel 100 may be bent downward.

The display circuit board 300 may be attached onto display pads of the display panel 100 using an anisotropic conductive film ("ACF"). Therefore, the display circuit board 300 may be electrically connected to the display pads of the display panel 100. The display circuit board 300 may be a flexible printed circuit board, a printed circuit board, or a flexible film such as a chip on film.

The encapsulation substrate 500 (i.e., the second substrate) is disposed on the display panel 100. The encapsulation substrate 500 is spaced apart from the display panel 100 in the third direction DR3 to face the display panel 100 and may be smaller in a planar area than the display panel 100 but may cover at least the display area DPA of the display panel 100. However, the present disclosure according to the invention is not limited thereto. In another embodiment, the encapsulation substrate 500 may also have substantially the same planar area as the display panel 100 to cover the display area DPA and the non-display area NDA of the display panel 100. The encapsulation substrate 500 may seal the light emitting elements EL and circuit elements disposed in the display panel 100 together with the sealing member 700 to be described later. In addition, in some embodiments, a touch member, a polarizing member, etc. may be further disposed on the encapsulation substrate 500.

In an exemplary embodiment, the encapsulation substrate 500 may be a transparent plate or a transparent film. For example, the encapsulation substrate 500 may include a glass material or a quartz material. In some embodiments, the encapsulation substrate 500 may be spaced apart from the light emitting elements EL, and an inert gas such as nitrogen gas may fill a space between them. However, the present disclosure according to the invention is not limited thereto. In another embodiment, a filler or the like may also fill the space between the encapsulation substrate 500 and the light emitting elements EL.

The sealing member 700 may be disposed between the display panel 100 and the encapsulation substrate 500. For example, the sealing member 700 may be disposed in the non-display area NDA of the display panel 100 to surround the display area DPA and may seal the light emitting elements EL and the circuit elements of the display panel 100 together with the encapsulation substrate 500. In the display area DPA of the display panel 100, cells CL may be disposed. The cell CL includes a plurality of circuit elements and a plurality of insulating layers as well as the light emitting elements EL to be described later. The sealing member 700 may seal a space in which the cells CL of the display panel 100 are disposed between the encapsulation substrate 500 and the display panel 100, and moisture or air may be removed from the space during a fabrication process of the display device 10 to leave the space in a vacuum. The sealing member 700 may prevent the light emitting elements EL (see FIG. 5) from being damaged by air or moisture together with the encapsulation substrate 500.

The sealing member 700 may bond the display panel 100 and the encapsulation substrate 500 together. The sealing member 700 may be disposed in the non-display area NDA of the display panel 100 to contact and adhere to an upper surface of the display panel 100 and a lower surface of the encapsulation substrate 500.

In some embodiments, the sealing member 700 may be a cured frit. In the present specification, 'frit' may refer to a structure having glass properties formed by melt-curing glass in powder form optionally added with an additive. The glass in powder form may be placed between the display panel 100 and the encapsulation substrate 500 and then formed into a frit that bonds the display panel 100 and the encapsulation substrate 500 together through a baking and melting process. A case where the sealing member 700 is a cured frit will be described below as an example.

Since the sealing member 700 is formed through the baking and melting process during the fabrication process of the display device 10, the display panel 100 and the encapsulation substrate 500 may be coupled to each other through physical bonding with the sealing member 700. According to an embodiment, the display device 10 includes a plurality of support members 900 disposed in the display area DPA in addition to the sealing member 700 disposed in the non-display area NDA. Each of the support members 900 directly contacts the display panel 100 and the encapsulation substrate 500 and further includes a fused area without a physical boundary at least at a boundary with the encapsulation substrate 500. The display device 10 including the support members 900 can improve the adhesion between the encapsulation substrate 500 and the display panel 100.

In addition, the display device 10 may further include a fused portion at a boundary between each support member 900 and the encapsulation substrate 500 or the display panel 100. The support members 900 may be fused and bonded to at least the encapsulation substrate 500 such that the boundary between each support member 900 and each of the display panel 100 and the encapsulation substrate 500 includes a portion where no physical boundary exists in addition to a portion where a physical boundary exists. Since the display device 10 includes the fused part, each support member 900 can be bonded to the display panel 100 and the encapsulation substrate 500 with increased adhesion, and the durability of the display device 10 against external impact can be improved. This will be described in more detail later.

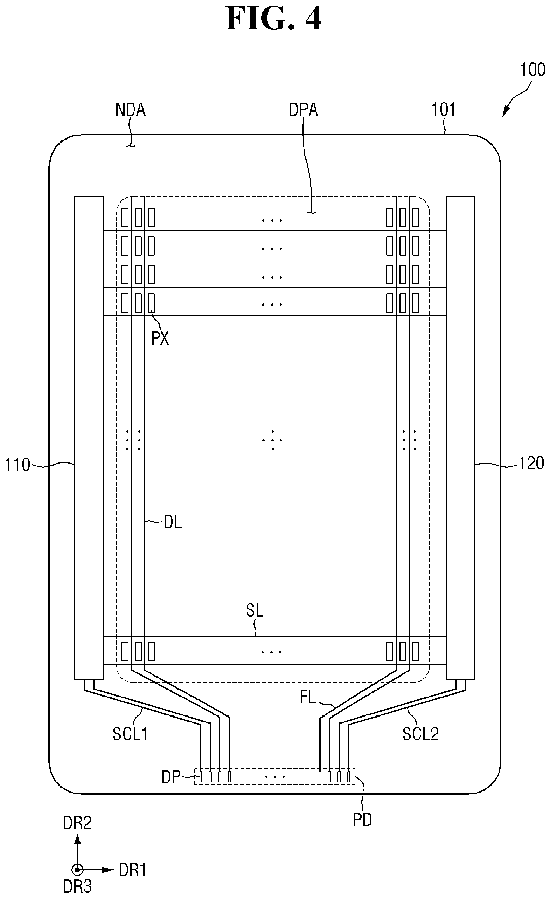

FIG. 4 is a schematic plan view of the display panel 100 according to an embodiment.

In FIG. 4, only the pixels PX, scan wirings SL, data wirings DL, first scan control wirings SCL1, second scan control wirings SCL2, a first scan driver 110, a second scan driver 120, pad area PD, display pads DP, and fan-out wirings FL of the display panel 100 are illustrated for ease of description.

Referring to FIG. 4, the display panel 100 may include the display area DPA in which the pixels PX are formed to display an image and the non-display area NDA disposed around the display area DPA. The non-display area NDA may be an area extending from the outside of the display area DPA to edges of the display panel 100.

The scan wirings SL, the data wirings DL, and the pixels PX may be disposed in the display area DPA. The scan wirings SL may extend parallel to each other in the first direction DR1, and the data wirings DL may extend parallel to each other in the second direction DR2 intersecting the first direction DR1.

Each of the pixels PX may be connected to at least any one of the scan wirings SL and any one of the data wirings DL. Each of the pixels PX may include thin-film transistors including a driving transistor and at least one switching transistor, an organic light emitting diode, and a capacitor. Each of the pixels PX may receive a data voltage of a data wiring DL in response to a scan signal transmitted from a scan wiring SL and may emit light by supplying a driving current to the organic light emitting diode according to the data voltage applied to a gate electrode of the driving transistor. The structure of the elements disposed in each of the pixels PX will be described in detail later with reference to FIG. 5.

The first scan driver 110, the second scan driver 120, the display driver 200 (See FIG. 1), the first scan control wirings SCL1, the second scan control wirings SCL2, and the fan-out wirings FL may be disposed in the non-display area NDA.

The first scan driver 110 is connected to the display driver 200 through the first scan control wirings SCL1. Therefore, the first scan driver 110 may receive a first scan control signal of the display driver 200. The first scan driver 110 generates scan signals according to the first scan control signal and supplies the scan signals to the scan wirings SL.

The second scan driver 120 is connected to the display driver 200 through the second scan control wirings SCL2. Therefore, the second scan driver 120 may receive a second scan control signal of the display driver 200. The second scan driver 120 generates scan signals according to the second scan control signal and supplies the scan signals to the scan wirings SL.

The first scan driver 110 may be connected to the scan wirings SL connected to the pixels PX of the display area DPA. The second scan driver 120 may be connected to the scan wirings SL connected to the pixels PX.

The fan-out wirings FL connect the display pads DP to the data wirings DL, the first scan driver 110, and the second scan driver 120. That is, the fan-out wirings FL may be disposed between the display pads DP and the data wirings DL, between the display pads DP and the first scan driver 110, and between the display pads DP and the second scan driver 120.

A pad area PD may include the display pads DP. The pad area PD may be disposed at an edge of a base substrate 101 (see FIG. 5) of the display panel 100. For example, the pad area PD may be disposed at a lower edge of the base substrate 101 (see FIG. 5).

FIG. 5 is a cross-sectional view of a pixel PX included in the display device 10 according to the embodiment. FIG. 5 illustrates a cross-section of a portion of any one pixel PX disposed in the display area DPA.

Referring to FIG. 5, the display panel 100 may include the base substrate 101 and a thin-film transistor T1 and a light emitting element EL disposed on the base substrate 101. Each pixel PX of the display panel 100 may include at least one thin-film transistor T1 and the light emitting element EL and may be connected to a scan wiring SL and a data wiring DL described above. Although one thin-film transistor T1 is disposed in one pixel PX in the drawing, the present disclosure according to the invention is not limited thereto.

The base substrate 101 may be a rigid substrate. The base substrate 101 may be made of or include an insulating material such as glass, quartz, or polymer resin. The polymer material may be, for example, polyethersulphone ("PES"), polyacrylate ("PA"), polyarylate ("PAR"), polyetherimide ("PEI"), polyethylene naphthalate ("PEN"), polyethylene terephthalate ("PET"), polyphenylene sulfide ("PPS"), polyallylate, polyimide ("PI"), polycarbonate ("PC"), cellulose triacetate ("CAT"), cellulose acetate propionate ("CAP"), or a combination of the same. The base substrate 101 may also include a metal material.

A buffer layer 102 may be disposed on the base substrate 101. The buffer layer 102 may be formed on the base substrate 101 to protect the thin-film transistor T1 and the light emitting element EL from moisture introduced through the base substrate 101 which is vulnerable to moisture penetration. The buffer layer 102 may be composed of or include a plurality of inorganic layers stacked alternately. For example, the buffer layer 102 may be a multilayer in which one or more inorganic materials selected from silicon oxide (SiOx), silicon nitride (SiNx), and silicon oxynitride (SiON) are alternately stacked. The buffer layer 102 is optional.

The thin-film transistor T1 is disposed on the buffer layer 102. The thin-film transistor T1 may include an active layer ACT1, a gate electrode G1, a source electrode S1 and a drain electrode D1. In FIG. 5, the thin-film transistor T1 is formed in a top gate manner in which the gate electrode G1 is located above the active layer ACT1. However, it should be noted that the present disclosure according to the invention is not limited thereto. That is, the thin-film transistor T1 may also be formed in a bottom gate manner in which the gate electrode G1 is located under the active layer ACT1 or a double gate manner in which the gate electrode G1 is located both above and under the active layer ACT1 in another embodiment.

The active layer ACT1 is disposed on the buffer layer 102. The active layer ACT1 may be made of or include a silicon-based semiconductor material or an oxide-based semiconductor material. Although not illustrated in the drawing, a light blocking layer may be disposed between the buffer layer 102 and the active layer ACT1 to block external light from entering the active layer ACT1.

A gate insulating layer 103 may be disposed on the active layer ACT1. The gate insulating layer 103 may be an inorganic layer, for example, a multilayer in which one or more inorganic materials selected from silicon oxide (SiOx), silicon nitride (SiNx), and silicon oxynitride (SiON) are alternately stacked.

The gate electrode G1 and a gate line may be disposed on the gate insulating layer 103. Each of the gate electrode G1 and the gate line may be a single layer or a multilayer made of any one or more of molybdenum (Mo), aluminum (Al), chromium (Cr), gold (Au), titanium (Ti), nickel (Ni), neodymium (Ne), copper (Cu), and alloys of the same.

An interlayer insulating layer 105 may be disposed on the gate electrode G1 and the gate line. The interlayer insulating layer 105 may be an inorganic layer, for example, a multilayer in which one or more inorganic materials selected from silicon oxide (SiOx), silicon nitride (SiNx), and silicon oxynitride (SiON) are alternately stacked.

The source electrode S1, the drain electrode D1, and a data line may be disposed on the interlayer insulating layer 105. Each of the source electrode S1 and the drain electrode D1 may be connected to the active layer ACT1 through a contact hole penetrating the gate insulating layer 103 and the interlayer insulating layer 105. Each of the source electrode S1, the drain electrode D1, and the data line may be a single layer or a multilayer made of any one or more of molybdenum (Mo), aluminum (Al), chromium (Cr), gold (Au), titanium (Ti), nickel (Ni), neodymium (Ne), copper (Cu), and alloys of the same.

A protective layer 107 for insulating the thin-film transistor T1 may be disposed on the source electrode S1, the drain electrode D1, and the data line. The protective layer 107 may be an inorganic layer, for example, a multilayer in which one or more inorganic materials selected from silicon oxide (SiOx), silicon nitride (SiNx), and silicon oxynitride (SiON) are alternately stacked.

A planarization layer 108 is disposed on the protective layer 107. The planarization layer 108 may planarize a step due to the thin-film transistor T1. The planarization layer 108 may be made of or include an organic layer such as acryl resin, epoxy resin, phenolic resin, polyamide resin, or polyimide resin.

A pixel defining layer 109 and the light emitting element EL are disposed on the planarization layer 108.

The light emitting element EL may be an organic light emitting device. In this case, the light emitting element EL may include an anode AND, a light emitting layer OL, and a cathode CTD.

The anode AND may be disposed on the planarization layer 108. The anode AND may be connected to the source electrode S1 of the thin-film transistor T1 through a contact hole penetrating the protective layer 107 and the planarization layer 108.

The pixel defining layer 109 may be disposed on the planarization layer 108 to cover edges of the anode AND so as to partition the pixels PX. That is, the pixel defining layer 109 serves as a pixel defining layer that defines the pixels PX. Each pixel PX is an area where the anode AND, the light emitting layer OL and the cathode CTD are sequentially stacked such that holes from the anode AND and electrons from the cathode CTD combine in the light emitting layer OL to emit light.

The light emitting layer OL is disposed on the anode AND and the pixel defining layer 109. The light emitting layer OL may be an organic light emitting layer. The light emitting layer OL may emit one of red light, green light, and blue light. Alternatively, the light emitting layer OL may be a white light emitting layer that emits white light. In this case, the light emitting layer OL may be a stack of a red light emitting layer, a green light emitting layer and a blue light emitting layer and may be a common layer common to all of the pixels PX. In this case, the display panel 100 may further include separate color filters for displaying red, green and blue.

The light emitting layer OL may include a hole transporting layer, a light emitting layer, and an electron transporting layer. In addition, the light emitting layer OL may have a tandem structure of two or more stacks, in which case a charge generating layer may be disposed between the stacks.

The cathode CTD is disposed on the light emitting layer OL. The cathode CTD may be disposed to cover the light emitting layer OL. The cathode CTD may be a common layer common to all of the pixels PX.

When the light emitting element EL of the display panel 100 is a top emission type which emits light in the upward direction, the anode AND may be made of or include a metal material having high reflectivity, such as a stacked structure (Ti/Al/Ti) of aluminum and titanium, a stacked structure (ITO/Al/ITO) of aluminum and indium tin oxide, an APC alloy, or a stacked structure (ITO/APC/ITO) of an Ag-Pd-Cu ("APC") alloy and indium tin oxide. The APC alloy is an alloy of silver (Ag), palladium (Pd), and copper (Cu). In addition, the cathode CTD may be made of a transparent conductive material ("TCO") capable of transmitting light, such as indium tin oxide ("ITO") or indium zinc oxide ("IZO"), or a semi-transmissive conductive material such as magnesium (Mg), silver (Ag) or an alloy of Mg and Ag. When the cathode CTD is made of or include a semi-transmissive conductive material, light output efficiency may be increased by a microcavity.

When the light emitting element EL is a bottom emission type which emits light in the downward direction, the anode AND may be made of or include a transparent conductive material (TCO) such as indium tin oxide (ITO) or indium zinc oxide (IZO) or a semi-transmissive conductive material such as magnesium (Mg), silver (Ag) or an alloy of Mg and Ag. The cathode CTD may be made of or include a metal material having high reflectivity, such as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. When the anode AND is made of or include a semi-transmissive conductive material, the light output efficiency may be increased by a microcavity.

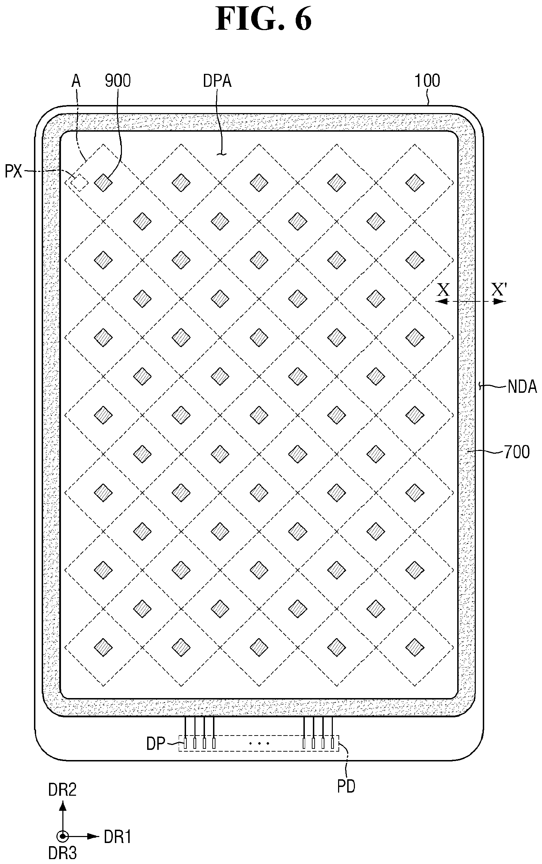

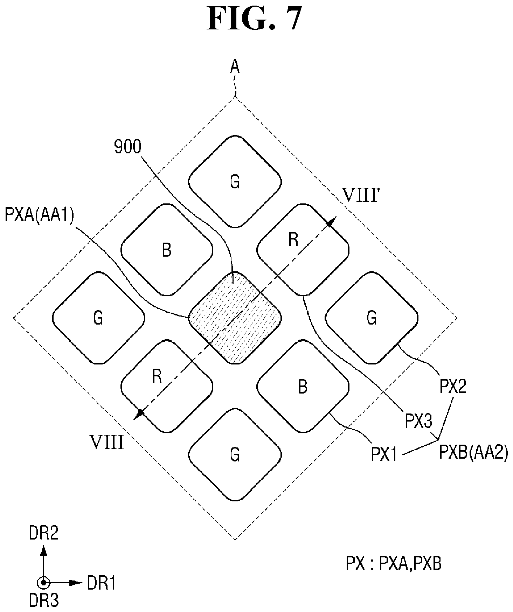

FIG. 6 is a plan view illustrating the sealing member 700 and the support members 900 disposed on the display panel 100 according to the embodiment. FIG. 7 is an enlarged view of portion A of FIG. 6. FIG. 6 illustrates the schematic arrangement of the sealing member 700 disposed in the non-display area NDA of the display panel 100 and the support members 900 disposed in the display area DPA, and FIG. 7 illustrates a plurality of pixels PX disposed in the display area DPA.

Referring to FIGS. 6 and 7, the display panel 100 of the display device 10 includes a plurality of pixels PX disposed in the display area DPA. The pixels PX may be arranged in two directions. For example, the pixels PX may be disposed over the entire display area DPA in a particular direction intersecting and oblique to both the first direction DR1 and the second direction DR2 and the other direction perpendicular to the particular direction. In the drawings, the pixels PX are spaced apart from each other by a predetermined distance. In each space between the pixels PX, another member such as a spacer or a separate structure may be disposed, but the present disclosure according to the invention is not limited thereto. Alternatively, the pixels PX may be disposed substantially adjacent to each other without being spaced apart from each other, but may be areas distinguished based on spaces in which the light emitting elements EL (see FIG. 5) or the circuit elements are repeatedly disposed.

The display device 10 according to the embodiment may include the sealing member 700 which is disposed in the non-display area NDA to surround the display area DPA and a plurality of support members 900 which are spaced apart from each other in the display area DPA and form patterns in the entire display area DPA.

The sealing member 700 may be disposed in the non-display area NDA of the display panel 100 to surround the display area DPA while forming a closed curve in a plan view. As described above, the sealing member 700 may surround the light emitting elements EL disposed in the display area DPA and may seal the space between the encapsulation substrate 500 and the display panel 100. Moisture or air may be removed from the space during the fabrication process of the display device 10 to leave the space in a vacuum, and the sealing member 700 may prevent the light emitting elements EL from being damaged by air or moisture together with the encapsulation substrate 500.

The support members 900 are disposed in the display area DPA and spaced apart from each other by a predetermined distance. The support members 900 may form island-like patterns or linear patterns over the entire display area DPA.

The sealing member 700 may and the support members 900 contacts the upper surface of the display panel 100 and the lower surface of the encapsulation substrate 500. The sealing member 700 may surround the display area DPA and seal the space between the encapsulation substrate 500 and the display panel 100 in order to protect the light emitting elements EL of the display area DPA. In addition, the sealing member 700 may bond the display panel 100 and the encapsulation substrate 500 together. The sealing member 700 including a frit may directly contact and bond the display panel 100 and the encapsulation substrate 500. According to an embodiment, the display device 10 further including the support members 900 may improve the adhesion between the display panel 100 and the encapsulation substrate 500 in the display area DPA. Like the sealing member 700, the support members 900 directly contacts the display panel 100 and the encapsulation substrate 500 and bond them together. Other details including cross-sectional shapes of the sealing member 700 and the support members 900 will be described in detail later with reference to other drawings.

The display area DPA of the display panel 100 may be an area where the pixels PX including the light emitting elements EL are disposed and an area from which light emitted from the light emitting elements EL is output. The display device 10 includes the support members 900 disposed in at least a portion of the display area DPA, and the support members 900 are disposed only in an area where the light emitting elements EL are not disposed. According to an embodiment, the display panel 100 of the display device 10 may include first areas AA1 in which the support members 900 are disposed and a second area AA2 which is an area other than the first areas AA1 in the display area DPA and in which the support members 900 are not disposed. The first areas AA1 are areas where the support members 900 are disposed but the light emitting elements EL or the light emitting layers OL are not disposed, and the second area AA2 is an area where the support members 900 are not disposed and includes areas where the light emitting elements EL are disposed. The first areas AA1 and the second area AA2 may be distinguished based on whether the support members 900 are disposed regardless of whether the pixels PX are disposed in the display area DPA. Accordingly, in an embodiment, the support members 900 do not overlap the light emitting elements EL or the circuit elements, and, the display device 10 includes pixels PX in which the support members 900 are disposed and pixels PX in which the support members 900 are not disposed, or, in an example not forming part of the claimed invention, a support member 900 may be disposed in a portion of each pixel PX.

According to the claimed invention, the pixels PX of the display device 10 include first type pixels PXA in which the support members 900 are disposed and second type pixels PXB in which the support members 900 are not disposed. The pixels PX arranged in the display area DPA are divided into pixels (e.g., the first type pixels PXA) in which the support members 900 are disposed and the light emitting elements EL are not included and pixels (e.g., the second type pixels PXB) in which the support members 900 are not disposed and the light emitting elements EL are included. At least one first type pixel PXA may be disposed in each unit pixel area (e.g., portion A) including a plurality of pixels PX. For example, as illustrated in FIG. 7, nine pixels PX may be disposed in a unit pixel area (e.g., portion A of FIG. 6), and one first type pixel PXA and eight second type pixels PXB may be disposed in the unit pixel area (e.g., portion A). A plurality of first type pixels PXA may be disposed in a plurality of unit pixel areas (e.g., portion A), respectively, to form island-like patterns in the entire display area DPA. The first type pixels PXA may be arranged at regular intervals, and at least one second type pixel PXB may be located between the first type pixels PXA.

However, the present disclosure according to the invention is not limited thereto. The unit pixel area illustrated in FIG. 7 is just an example used to describe the current embodiment, and a unit pixel area may be an area defined for ease of description. In addition, an area where nine pixels are disposed is not necessarily defined as a unit pixel area. A plurality of pixels PX may be arranged in the display area DPA of the display panel 100, and some of the pixels PX may be the first type pixels PXA in which the support members 900 are disposed. That is, the display panel 100 may include a plurality of pixels defined as the first type pixels PXA in which the support members 900 are disposed, and the other pixels may be the second type pixels PXB in which the support members 900 are not disposed and the light emitting elements EL are disposed.

The second type pixels PXB may include a plurality of subpixels which emit light of different colors. For example, the second type pixels PBX may include first subpixels PX1 including the light emitting elements EL that emit light of a first color, second subpixels PX2 including the light emitting elements EL that emit light of a second color, and third subpixels PX3 including the light emitting elements EL that emit light of a third color. In an exemplary embodiment, the first color may be blue, the second color may be green, and the third color may be red, but the present disclosure according to the invention is not limited thereto.

The first subpixels PX1, the second subpixels PX2, and the third subpixels PX3 may be arranged in the display area DPA of the display panel 100 in two directions and may alternate with each other. For example, at least one subpixel (e.g., a second subpixel PX2 or a third subpixel PX3) may be disposed between a plurality of first subpixels PX1. The same type of subpixels PX1, PX2 or PX3 may not be successively disposed along either direction in which they are arranged and may be spaced apart from each other.

In some embodiments, the display panel 100 may include at least any one type of subpixels among the first through third subpixels PX1 through PX3 in a larger number than the other types of subpixels. Among the first through third subpixels PX1 through PX3 disposed in a unit pixel area, any one type of subpixels may be included in a larger number than the other subpixels, and any one of the type of subpixels included in a larger number may be replaced with a first type pixel PXA. For example, the display panel 100 may include the second subpixels PX2 (e.g., green color pixel) which emit light of the second color in a larger number than the number of the first subpixels PX1 and than the number of the third subpixels PX3 in a unit pixel area.

Accordingly, any one of the second subpixels PX2 may be replaced with a first type pixel PXA, and subpixels neighboring the first type pixel PXA in two directions in which a plurality of pixels PX are arranged may be the first subpixels PX1 or the third subpixels PX3. As described above, the same type of subpixels PX1, PX2 or PX3 do not neighbor each other, and at least one other subpixel may be disposed between the same type of subpixels PX1, PX2 or PX3. Since each second subpixel PX2 neighbors the first or third subpixels PX1 or PX3, the first type pixel PXA may neighbor the first subpixels PX1 or the third subpixels PX3. However, the present disclosure according to the invention is not limited thereto, and the first type pixel PXA may also be replaced with a first subpixel PX1 or a third subpixel PX3 in another embodiment.

The second type pixels PXB, that is, the first through third subpixels PX1 through PX3 do not include the support members 900 but include the light emitting elements EL and the circuit elements for driving the light emitting elements EL. That is, the pixel PX illustrated in FIG. 5 may be understood as a cross-section of a portion of a second type pixel PXB. On the other hand, the first type pixels PXA include the support members 900 but do not include the light emitting elements EL and the circuit elements for driving the light emitting elements EL. The support members 900 are directly disposed on the base substrate 101 of the display panel 100 in areas defined as the first type pixels PXA, and at least a portion of an upper surface of each support member 900 directly contacts the lower surface of the encapsulation substrate 500. The support members 900 directly contact the base substrate 101 and the encapsulation substrate 500 and bond them together. The support members 900 will be described in more detail with further reference to other drawings.

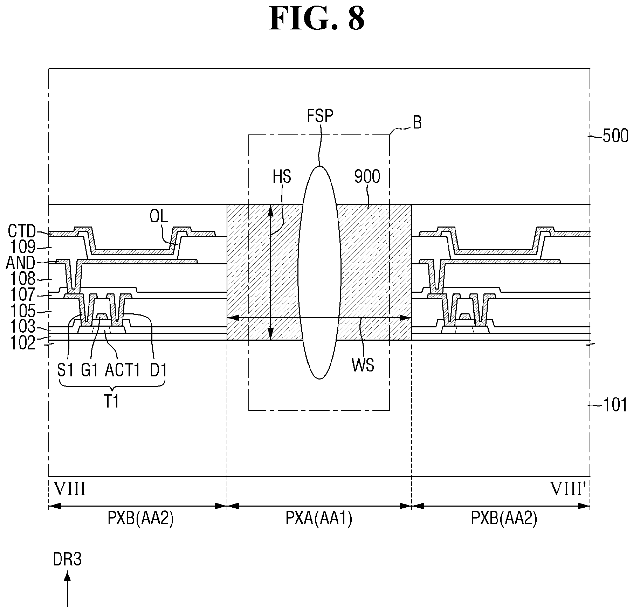

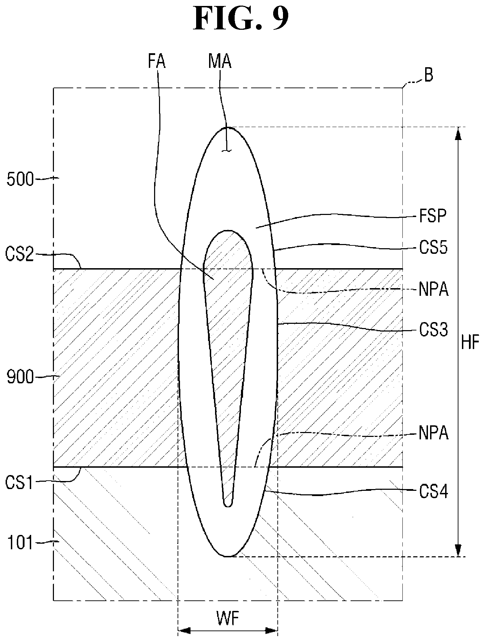

FIG. 8 is a cross-sectional view taken along line VIII-VIII' of FIG. 7. FIG. 9 is an enlarged view of portion B of FIG. 8. FIG. 8 illustrates a partial cross-section of a first type pixel PXA and second type pixels PXB among the pixels PX included in the display panel 100. FIG. 9 is an enlarged view of a portion B of a support member 900 illustrated in FIG. 8.

Referring to FIGS. 8 and 9, the support member 900 is disposed in the first type pixel PXA located between the second type pixels PXB including the light emitting elements EL. A plurality of insulating layers disposed in the second type pixels PXB may contact the support member 900 at boundaries with the first type pixel PXA. However, the present disclosure according to the invention is not limited thereto, and the insulating layers of the second type pixels PXB may also be spaced apart from the support member 900 in another embodiment.

The support member 900 is directly disposed on the base substrate 101 of the display panel 100. At least a portion of the lower surface of the support member 900 directly contacts an upper surface of the base substrate 101, and at least a portion of the upper surface of the support member 900 directly contacts the lower surface of the encapsulation substrate 500. Since the support member 900 directly contacts the base substrate 101 and the encapsulation substrate 500, the adhesion between the display panel 100 and the encapsulation substrate 500 may be improved. In some embodiments, the support member 900 may include at least any one of an inorganic insulating material such as silicon oxide (SiOX), silicon nitride (SiNx) or silicon oxynitride (SiOxNy) and an organic insulating material such as polyimide (PI) or photoresist ("PR"). Although the support member 900 is illustrated as a single layer in the drawings, the present disclosure according to the invention is not limited thereto. The support member 900 may also have a structure in which a plurality of layers including the above materials are sequentially stacked in another embodiment.

According to an embodiment, the display device 10 includes a fusion pattern FSP in which the support member 900 is fused with the encapsulation substrate 500 and optionally with the display panel 100 such that no physical boundary exists between them. The thrfusion pattern FSP is disposed at least at a boundary formed by the support member 900 and the encapsulation substrate 500. The fusion pattern FSP is disposed over the encapsulation substrate 500, the support member 900, and the display panel 100. A height HF of the fusion pattern FSP in the third direction DR3 may be greater than a thickness HS of the support member 900, and at least a portion of the fusion pattern FSP is disposed in the encapsulation substrate 500 and may be disposed in the base substrate 101 of the display panel 100. Although the fusion pattern FSP extends from the base substrate 101 of the display panel 100 to the encapsulation substrate 500 via the support member 900 in the drawings, the present disclosure according to the invention is not limited thereto. The fusion pattern FSP is disposed at least over the boundary between the support member 900 and the encapsulation substrate 500 to reinforce the interfacial adhesion between the sealing member 700 and the encapsulation substrate 500.

According to an embodiment, the fusion pattern FSP may be an area where the support member 900, the display panel 100 and the encapsulation substrate 500 are fused such that no physical boundary exists between them and may be an area formed by mixing of the material that forms the support member 900 and the material that forms the display panel 100 or the encapsulation substrate 500. For example, when the support member 900 is disposed to directly contact the encapsulation substrate 500 and the base substrate 101 of the display panel 100, the fusion pattern FSP may be formed by mixing of the materials that form the encapsulation substrate 500, the base substrate 101 and the support member 900.

The fusion pattern FSP may be a portion of the material that forms the support member 900 flows into the encapsulation substrate 500 and the base substrate 101, a portion of the material that forms each of the encapsulation substrate 500 and the base substrate 101 flows into the support member 900, and then these materials are mixed with each other. Accordingly, in a portion where the fusion pattern FSP is formed, no physical boundary may exist between the upper surface of the support member 900 and the lower surface of the encapsulation substrate 500. In addition, in the portion where the fusion pattern FSP is formed, no physical boundary may exist between the lower surface of the support member 900 and the upper surface of the display panel 100 or the base substrate 101. Since the fusion pattern FSP is formed by the fusing of the support member 900, the encapsulation substrate 500 and the display panel 100 and the mixing of the materials that form them, the adhesion between the display panel 100 and the encapsulation substrate 500 may be further improved. Although only one fusion pattern FSP is illustrated in a widthwise direction of the support member 900 in the drawings, the present disclosure according to the invention is not limited thereto. A plurality of fusion patterns FSP may also be formed along the widthwise direction of the support member 900 and may be spaced apart from each other.

As described above, the support member 900 includes a portion physically contacting the display panel 100 and the encapsulation substrate 500 at its boundary with the display panel 100 and the encapsulation substrate 500. The support member 900 directly contacts the display panel 100 and the encapsulation substrate 500, and a physical boundary exists in an area where they contact each other. A physical boundary exists between the lower surface of the encapsulation substrate 500 and the upper surface of the support member 900 and between the upper surface of the base substrate 101 of the display panel 100 and the lower surface of the support member 900.

The fusion pattern FSP may be formed over at least a portion of the boundary formed by the support member 900 and each of the display panel 100 and the encapsulation substrate 500. The fusion pattern FSP may be an area where the support member 900 is fused with each of the display panel 100 and the encapsulation substrate 500 without a physical boundary between them. According to an embodiment, the fusion pattern FSP may include a fusion area FA in which the material that forms the support member 900 is fused with the materials that form the base substrate 101 of the display panel 100 and the encapsulation substrate 500, and a molten area MA which surrounds the fusion area FA and in which the materials that form the support member 900, the display panel 100 and the encapsulation substrate 500 are melted and mixed with each other.

The fusion area FA may be a portion where the materials of the support member 900, the encapsulation substrate 500 and the display panel 100 are fused by plasma generated by a pulsed laser irradiated to form the fusion pattern FSP during the fabrication process of the display device 10. The molten area MA may be an area formed around the fusion area FA and melted by high heat of the plasma and then solidified. In the molten area MA, the materials that form the support member 900, the encapsulation substrate 500 and the display panel 100 may also be mixed with each other. According to an embodiment, the fusion pattern FSP including the fusion area FA and the molten area MA can more firmly bond the display panel 100 and the encapsulation substrate 500 together.

Specifically, the support member 900 may include a first boundary surface CS1 that forms a physical boundary with the upper surface of the base substrate 101 of the display panel 100 and a second boundary surface CS2 that forms a physical boundary with the lower surface of the encapsulation substrate 500. According to an embodiment, the fusion pattern FSP formed across the support member 900 between the display panel 100 and the encapsulation substrate 500 may include a third boundary surface CS3 formed between the support member 900 and the fusion pattern FSP, a fourth boundary surface CS4 formed between the base substrate 101 of the display panel 100 and the fusion pattern FSP, and a fifth boundary surface CS5 formed between the encapsulation substrate 500 and the fusion pattern FSP. Each of the first boundary surface CS1 and the second boundary surface CS2 is a surface where the support member 900 contacts the display panel 100 or the encapsulation substrate 500 and may be a physically defined boundary. At the first boundary surface CS1 and the second boundary surface CS2, the material that forms the support member 900 does not move to the display panel 100 or the encapsulation substrate 500 or is not mixed with the material that forms the display panel 100 or the encapsulation substrate 500. The support member 900 may be kept bonded to the display panel 100 and the encapsulation substrate 500 at the first boundary surface CS1 and the second boundary surface CS2, respectively.

The fusion pattern FSP may include the fusion area FA and the molten area MA. In an extended portion of the first boundary surface CS1, a portion NPA (see FIG. 9) where no physical boundary exists may be formed in a portion where the fusion pattern FSP is formed. In addition, in an extended portion of the second boundary surface CS2 and at the upper surface of the display panel 100 or the base substrate 101, the area NPA where no physical boundary exists may be formed in a portion where the fusion pattern FSP is formed. That is, a fused area without a physical boundary may be formed at at least a portion of a boundary surface between the support member 900 and the display panel 100 or the encapsulation substrate 500.

The third through fifth boundary surfaces CS3 through CS5 may be boundary surfaces formed with the fusion pattern FSP inside the support member 900, the base substrate 101 of the display panel 100, and the encapsulation substrate 500, respectively. According to an embodiment, unlike the first boundary surface CS1 and the second boundary surface CS2, the third through fifth boundary surfaces CS3 through CS5 of the fusion pattern FSP may not be physical boundaries but may be boundaries formed between areas having different components according to their positions. The fusion pattern FSP may be formed by the mixing of the materials that form the base substrate 101 of the display panel 100, the encapsulation substrate 500, and the support member 900. Since the materials of the base substrate 101, the support member 900 and the encapsulation substrate 500 are all included and mixed in the fusion pattern FSP, they may all be detected in the fusion pattern FSP. For example, an insulating material component which is a first component forming the support member 900 and a glass component which is a second component forming the base substrate 101 and the encapsulation substrate 500 may be detected in a mixed state in the fusion pattern FSP. On the other hand, since only the insulating material component is detected in the support member 900 and only the glass component is detected in the base substrate 101 and the encapsulation substrate 500, boundaries, albeit not physical boundaries, may be formed at the third through fifth boundary surfaces CS3 through CS5 of the fusion pattern FSP due to component differences.

In an embodiment, the fusion pattern FSP may include the second component of the encapsulation substrate 500 or the base substrate 101 in a greater amount than the first component of the support member 900 based on the third boundary surface CS3. Similarly, the fusion pattern FSP may include the first component of the support member 900 in a greater amount than the second component of the base substrate 101 based on the fourth boundary surface CS4 and include the first component of the support member 900 in a greater amount than the second component of the encapsulation substrate 500 based on the fifth boundary surface CS5. However, since the base substrate 101, the support member 900, the encapsulation substrate 500 and the fusion pattern FSP include common components based on the third through fifth boundary surfaces CS3 through CS5, there may be no physical boundary between them.

The fusion pattern FSP may be formed as the support member 900, the display panel 100 and the encapsulation substrate 500 are partially fused by a pulsed laser irradiated from an upper surface of the encapsulation substrate 500 during the fabrication process of the display device 10. As will be described later, the pulsed laser may be set such that its focus is located inside the display panel 100, and mixing of materials may occur at the boundary between each of the display panel 100 and the encapsulation substrate 500 and the support member 900.

However, the present disclosure according to the invention is not limited thereto. The fusion pattern FSP disposed in the display area DPA of the display device 10 may be variously changed in its shape and placement according to a location from which the pulsed laser is irradiated in another embodiment. The display device 10 including the fusion pattern FSP disposed at least over the boundary between the encapsulation substrate 500 and the support member 900 may improve the adhesion between the encapsulation substrate 500 and the display panel 100.

The fusion pattern FSP may extend in the thickness direction (i.e., the third direction DR3) of the display device 10. The fusion pattern FSP may have a maximum width WF in a portion overlapping the support member 900 in a plan view and may become narrower toward the display panel 100 and the encapsulation substrate 500. For example, in the fusion pattern FSP, the portion overlapping the support member 900 may be wider than both ends in the direction in which the fusion pattern FSP extends. In addition, the fusion area FA of the fusion pattern FSP may include a first portion overlapping the display panel 100, a second portion overlapping the support member 900, and a third portion overlapping the encapsulation substrate 500. The maximum width of the third portion may be greater than maximum widths of the first portion and the second part. In addition, the maximum width of the second portion may be greater than the maximum width of the first part.

The pulsed laser used to form the fusion pattern FSP may be set such that its focus is located inside the display panel 100, and the maximum width of the fusion area FA of the fusion pattern FSP may increase in a direction from the first portion toward the third part. Since the first portion of the fusion area FA is located closer to the laser focus than the second part, it may have inclined side surfaces and may be connected to the second part. The second portion may have a maximum width in the area NPA where no physical boundary exists at the lower surface of the encapsulation substrate 500. The maximum width of the third portion may be the maximum width of the fusion area FA. Since the third portion is located farther from the laser focus than the second part, the maximum width of the third portion may be greater than the maximum width of the second part.

The maximum width WF and the height HF of the fusion pattern FSP in the third direction DR3may vary according to the thickness HS of the support member 900. The thickness HS of the support member 900 may be adjusted according to a gap between the display panel 100 and the encapsulation substrate 500, and a width WS of the support member 900 may vary according to the size and unit area of each pixel PX. In an exemplary embodiment, the thickness HS of the support member 900 may be in the range of about 5 micrometers (*µ*m) to about 10 *µ*m or may be about 5 *µ*m. The width WS of the support member 900 or the width of each pixel PX may be in the range of about 20 *µ*m to about 30 *µ*m or may be about 25 *µ*m. The fusion pattern FSP may have the height HF in the third direction DR3 sufficient to extend from the base substrate 101 of the display panel 100 to the encapsulation substrate 500 and the maximum width WF sufficient to be formed in the support member 900. In some embodiments, the height HF of the fusion pattern FSP may be greater than the thickness HS of the support member 900, but the maximum width WF of the fusion pattern FSP may be smaller than the width WS of the support member 900. In an exemplary embodiment, the height HF of the fusion pattern FSP in the third direction DR3 may be in the range of about 10 *µ*m to about 20 *µ*m or in the range of about 12 *µ*m to about 18 *µ*m. The maximum width WF of the fusion pattern FSP may be in the range of about 8 *µ*m to about 12 *µ*m or in the range of about 9 *µ*m to about 11 *µ*m, preferably, may be about 10 *µ*m. However, the maximum width WF of the fusion pattern FSP may vary according to the gap between the display panel 100 and the encapsulation substrate 500 or the material or thickness of the support member 900. The above dimensions of the fusion pattern FSP are exemplary numerical ranges, and the present disclosure according to the invention is not limited thereto.

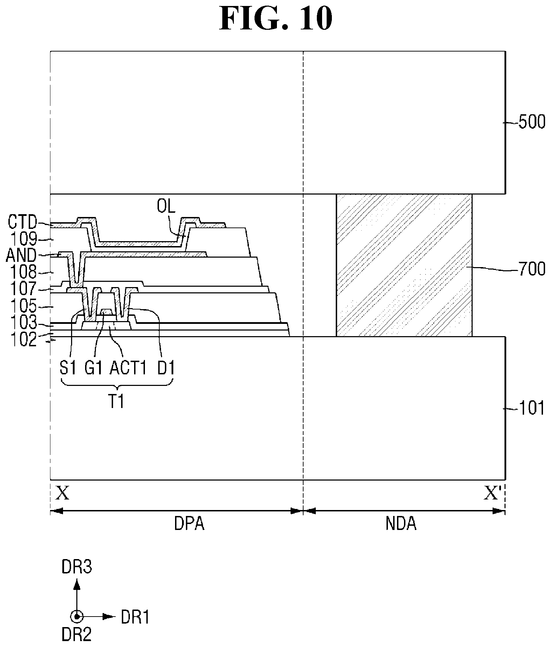

FIG. 10 is a cross-sectional view taken along line X-X' of FIG. 6. FIG. 10 illustrates a cross-section of a portion of the non-display area NDA of the display panel 100 which is located in the first direction DR1 of the display area DPA, that is, a cross-section of a portion where the sealing member 700 is disposed.

Referring to FIG. 10, the sealing member 700 may be disposed between the base substrate 101 and the encapsulation substrate 500 in the non-display area NDA of the display panel 100. According to an embodiment, at least a portion of the sealing member 700 may directly contact the upper surface of the base substrate 101 and the lower surface of the encapsulation substrate 500, and the display panel 100 and the encapsulation substrate 500 of the display device 10 may be bonded together by the sealing member 700. The sealing member 700 may include a frit to bond the display panel 100 and the encapsulation substrate 500 together through physical bonding with them, and a physical boundary may exist between the sealing member 700 and each of the base substrate 101 of the display panel 100 and the encapsulation substrate 500. However, the present disclosure according to the invention is not limited thereto. In some embodiments, the display device 10 may further include the fusion pattern FSP disposed at the boundary formed by the sealing member 700 and the encapsulation substrate 500 or the display panel 100, and the adhesion between the display panel 100 and the encapsulation substrate 500 may be further improved. This will be described with reference to another embodiment.

Since the adhesion between the display panel 100 and the encapsulation substrate 500 is sufficient due to the support member 900 included in the display device 10, a width of the sealing member 700 can be minimized to increase the display area DPA. In some embodiments, the width of the sealing member 700 may be in the range of about 10 *µ*m to about 100 *µ*m. The support member 900 may have a minimum possible width as long as its width is greater than the width WF of the fusion pattern FSP to secure a space in which the fusion pattern FSP can be formed. However, the present disclosure according to the invention is not limited thereto.

Since the fusion pattern FSP is formed at least by mixing of the materials that form the encapsulation substrate 500 and the support member 900, it may have a different refractive index from its surrounding area. For example, in the portion overlapping the support member 900, the fusion pattern FSP may include the material that forms the encapsulation substrate 500 more than the material that forms the support member 900. Thus, the fusion pattern FSP may have a different refractive index from the support member 900. According to an embodiment, since the fusion pattern FSP is formed by fusion of the encapsulation substrate 500, the display panel 100 and the support member 900, it may have a different refractive index from the support member 900 and improve the output efficiency of light emitted from the light emitting elements EL.

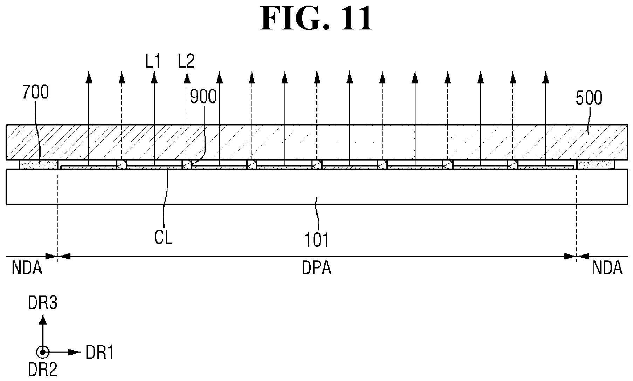

FIG. 11 is a schematic cross-sectional view illustrating emission of light through the support members 900 included in the display device 10 according to the embodiment. FIG. 11 schematically illustrates a cross-section of the display area DPA and the non-display area NDA of the display device 10.

Referring to FIG. 11, the display device 10 may include, in the display area DPA, the cells CL including the light emitting elements EL and the support members 900 bonding the display panel 100 and the encapsulation substrate 500 together. As described above, of the pixels PX disposed in the display area DPA, pixels PX in which the support members 900 are disposed are the first type pixels PXA, and the cells CL including the light emitting elements EL are the second type pixels PXB.

Light emitted from the light emitting elements EL of the second type pixels PXB may generally travel toward the upper surface of the display panel 100 or toward the encapsulation substrate 500 (L1 of FIG. 11). However, at least some of the light may travel in a lateral direction instead of the upward direction of the display panel 100. In each unit pixel area, a plurality of second type pixels PXB and at least one first type pixel PXA may be disposed. That is, each unit pixel area may include at least one support member 900. At least some of the light emitted from the second type pixels PXB disposed in each unit pixel area may travel toward the support member 900 (L2 of FIG. 11).

The support member 900 includes the fusion pattern FSP formed by fusion of at least the encapsulation substrate 500 and the support member 900 and thus mixing of the materials that form them, and the fusion pattern FSP may have a different refractive index from the support member 900. Light incident toward the support member 900 may be incident on the third boundary surface CS3 of the fusion pattern FSP through the support member 900 made of an inorganic or organic insulating material.

In an embodiment, the fusion pattern FSP may have a lower refractive index than the support member 900, and light incident on the fusion pattern FSP through the support member 900 may be totally reflected at the third boundary surface CS3. The totally reflected light may be reflected inside the support member 900 and then output through the encapsulation substrate 500. The display device 10 including the fusion pattern FSP formed to overlap the support member 900 may improve the output efficiency of light emitted from the light emitting elements EL.

In the display device 10 including the sealing member 700 disposed in the non-display area DPA of the display panel 100 and the support members 900 disposed in the display area DPA, the display panel 100 and the encapsulation substrate 500 may be firmly bonded together. In particular, since the fusion pattern FSP formed by fusion of at least the encapsulation substrate 500 and each support member 900 is disposed in the display area DPA, durability against external impact at the interface between each support member 900 and the encapsulation substrate 500 can be improved. According to an embodiment, since the display device 10 includes the support members 900, each having the fusion pattern FSP disposed at the boundary with at least the encapsulation substrate 500, in addition to the sealing member 700, the adhesion between the display panel 100 and the encapsulation substrate 500 can be improved. The display device 10 may have improved durability against external impact, and the light output efficiency of the light emitting elements EL through the support members 900 can be improved.

A method of fabricating the display device 10 according to the embodiment will now be described.

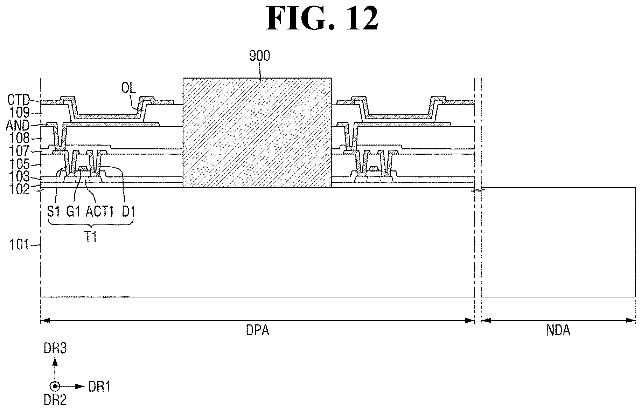

FIGS. 12 through 14 are cross-sectional views illustrating a process of fabricating a display device according to an embodiment.

First, referring to FIG. 12, a display panel 100 including a plurality of pixels PX and a support member 900 is prepared. As described above, the display panel 100 includes the pixels PX disposed in a display area DPA, and the pixels PX include a first type pixel PXA in which the support member 900 is disposed and second type pixels PXB in which the support member 900 is not disposed. A process of forming the support member 900 may be performed through a conventional process of forming an inorganic insulating material or an organic insulating material. In some embodiments, the support member 900 may be formed through a process such as sputtering or chemical vapor deposition ("CVD") when including an inorganic insulating material and may be formed through a photoresist (PR) or inkjet process when including an organic insulating material. However, the present disclosure according to the invention is not limited thereto.

In addition, although not illustrated in the drawing, an area where the first type pixel PXA including the support member 900 is formed may be secured by forming the second type pixels PXB and a plurality of insulating layers on a base substrate 101 over the entire display area DPA and then etching and removing parts where some insulating layers are disposed. Alternatively, in some cases, the support member 900 may be formed first, and then a process of forming the second type pixels PXB in other areas may be performed. This will not be described in detail here. In addition, a plurality of insulating layers, a semiconductor layer, and a plurality of conductive layers included in each pixel PX may be formed through a process that may be conventionally employed in the art to which the present disclosure pertains. The formation order or arrangement of the members included in the display device 10 will be mainly described below, and a description of processes of forming them will be omitted.

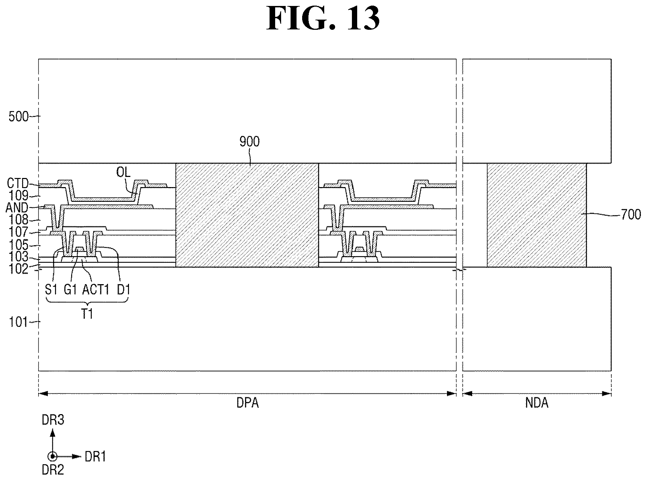

Next, referring to FIG. 13, an encapsulation substrate 500 is prepared, and the display panel 100 and the encapsulation substrate 500 are attached to each other through a sealing member 700 and the support member 900. The sealing member 700 may be disposed in a non-display area NDA of the display panel 100, and the support member 900 is disposed in the display area DPA. Each of the sealing member 700 and the support member 900 may directly contact the display panel 100 or the base substrate 101 and the encapsulation substrate 500. The sealing member 700 may be placed directly on a surface of the display panel 100, and then the encapsulation substrate 500 and the display panel 100 may be attached to each other, but the present disclosure according to the invention is not limited thereto. In some embodiments, the sealing member 700 may be formed on a surface of the encapsulation substrate 500, and then a process of attaching the display panel 100 and the encapsulation substrate 500 to each other may be performed.

The sealing member 700 may include a frit as described above and may be formed by printing the frit on the encapsulation substrate 500 or the display panel 100 and then drying and baking the frit. In some embodiments, the sealing member 700 may be formed by preparing frit crystals on a surface of the display panel 100 or the encapsulation substrate 500 and then drying and baking the frit crystals. The frit crystals may be glass in powder form optionally added with an additive. As described above, the sealing member 700 may include a frit, and frit crystals may be melt-cured to form a structure having glass properties, thereby forming the sealing member 700.

In the current operation, moisture and air existing in a space between the display panel 100 and the encapsulation substrate 500 may be removed, and the encapsulation substrate 500 and the sealing member 700 may seal the space.

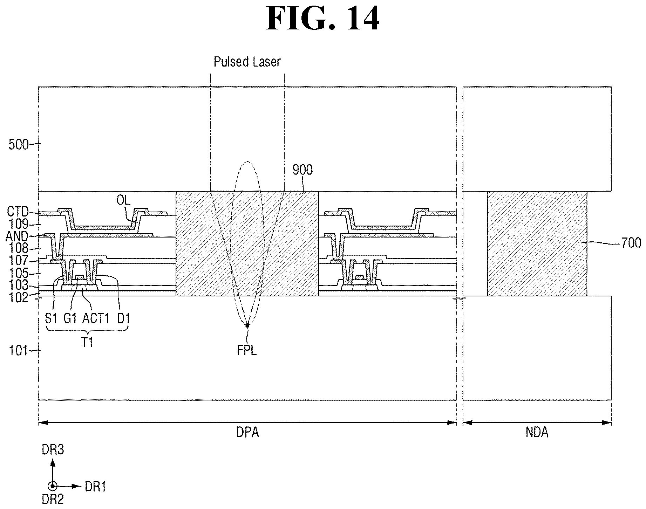

Next, referring to FIG. 14, a pulsed laser is irradiated to the support member 900 to form a fusion pattern FSP and partially fuse the display panel 100, the support member 900 and the encapsulation substrate 500. The pulsed laser may be irradiated at least to the support member 900, and the fusion pattern FSP disposed across the support member 900 may be formed between the display panel 100 and the encapsulation substrate 500. For example, the pulsed laser may be irradiated to the base substrate 101 of the display panel 100, the support member 900, and the encapsulation substrate 500. According to an embodiment, the support member 900 may be made of a transparent material through which light can be transmitted. The support member 900 may include a light transmitting material such that the pulsed laser can be irradiated across the encapsulation substrate 500 and the display panel 100. The pulsed laser may be irradiated from an upper surface of the encapsulation substrate 500 or a lower surface of the display panel 100 to reach the encapsulation substrate 500 or the display panel 100 after passing through the sealing member 700 and may cause the sealing member 700 to be fused with the display panel 100 and the encapsulation substrate 500.

According to an embodiment, the pulsed laser may be irradiated from the upper surface of the encapsulation substrate 500 and may be set such that a laser focus FPL is located inside the display panel 100. For example, the pulsed laser may be set such that a distance between the laser focus FPL and an upper surface of the display panel 100 is in the range of about 0.1 *µ*m to about 200 *µ*m. As described above, the fusion pattern FSP formed by the pulsed laser may include a fusion area FA which becomes wider as the distance from the laser focus FPL increases.

In some embodiments, the pulsed laser may be irradiated at a frequency of about 1 kilohertz (kHz) to about 10 megahertz (MHz) for about 10 femtoseconds (fs) to about 50 picoseconds (ps) and may have an energy of about 0.1 microjoules (µJ) or more. The pulsed laser may partially fuse materials that form the encapsulation substrate 500, the support member 900 and the display panel 100. In order not to damage light emitting elements EL included in the second type pixels PXB in the display area DPA, the pulsed laser may be irradiated only to the area where the first type pixel PXA or the support member 900 is located.

Since the display device 10 according to the embodiment includes the sealing member 700 and the support member 900 disposed between the display panel 100 and the encapsulation substrate 500 and the fusion pattern FSP having at least a portion disposed over the support member 900 and the encapsulation substrate 500, the adhesion between the display panel 100 and the encapsulation substrate 500 can be improved, and the durability of the display device 10 against external impact can be improved.

Various embodiments of the display device 10 will now be described with reference to other drawings.

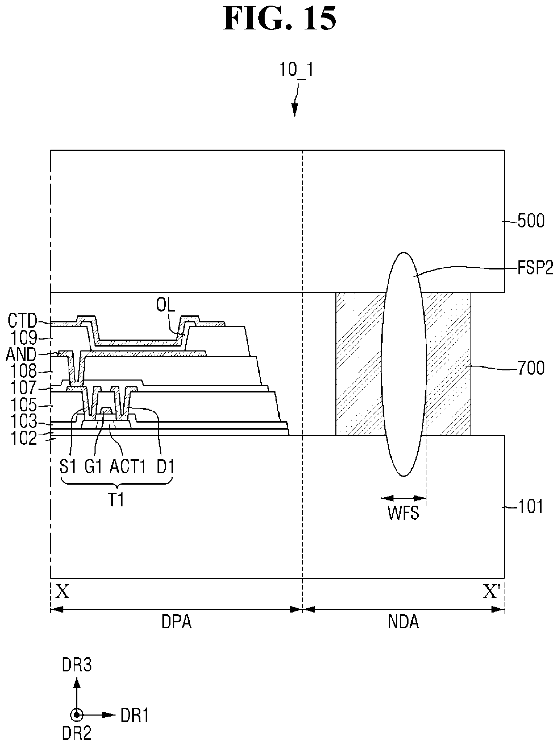

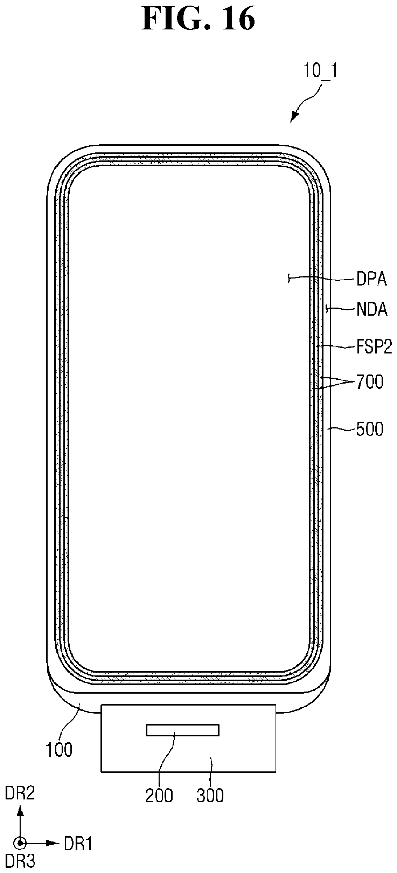

FIG. 15 is a cross-sectional view of a portion of a display device 10_1 according to an embodiment. FIG. 16 is a cross-sectional view illustrating a second fusion pattern FSP2 disposed in the display device 10_1 according to the embodiment.

Referring to FIGS. 15 and 16, the display device 10_1 according to the embodiment may include the second fusion pattern FSP2 disposed across a sealing member 700 in a non-display area NDA, in addition to fusion patterns FSP disposed across support members 900 in a display area DPA. The embodiment of FIGS. 15 and 16 is different from the embodiment of FIG. 10 in that the display device 10_1 further includes the second fusion pattern FSP2. A redundant description will be omitted, and differences will be mainly described below.

The display device 10_1 may include the fusion patterns FSP (i.e., first fusion patterns) disposed over the support members 900 and an encapsulation substrate 500 or a base substrate 101 of a display panel 100 to improve the adhesion between the display panel 100 and the encapsulation substrate 500. However, the present disclosure according to the invention is not limited thereto, and a pulsed laser may also be irradiated to the sealing member 700 during a fabrication process of the display device 10_1. Thus, the display device 10_1 may further include the second fusion pattern FSP2 formed by fusion of the sealing member 700 with the encapsulation substrate 500 and the base substrate 101 of the display panel 100. The display device 10_1 including the second fusion pattern FSP2 in addition to the first fusion patterns may further improve its durability against external impact.

The second fusion pattern FSP2 may have the same shape as each of the first fusion patterns disposed across the support members 900. However, since the second fusion pattern FSP2 is formed by fusion of the sealing member 700 with the encapsulation substrate 500 or the base substrate 101, it includes a mixture of materials that form them. That is, according to an embodiment, the second fusion pattern FSP2 may include a frit component that forms the sealing member 700 in addition to the material that forms the encapsulation substrate 500 or the base substrate 101. During the fabrication process of the display device 10_1, a pulsed laser may be irradiated to the sealing member 700 as well as to the support members 900, and the sealing member 700 may be fused with the base substrate 101 and the encapsulation substrate 500 to form the second fusion pattern FSP2.

The sealing member 700 may include a first extension portion extending in the first direction DR1 along the non-display area NDA, a second extension portion extending in the second direction DR2, and one or more curved corners connected to the first extension portion and the second extension part. The sealing member 700 may form a closed curve to surround the display area DPA and may include the first extension portion and the second extension portion corresponding to each short side of the display panel 100 extending in the first direction DR1 and each long side of the display panel 100 extending in the second direction DR2. The sealing member 700 may include one or more curved corners where the first extension portion and the second extension portion meet and may form a closed curve to surround the display area DPA.

The second fusion pattern FSP2 may be disposed in the non-display area NDA along the sealing member 700. Unlike the first fusion patterns which correspond to the support members 900 and are spaced apart from each other in the display area DPA to form island-like patterns, the second fusion pattern FSP2 may be disposed along the sealing member 700. That is, according to an embodiment, the second fusion pattern FSP2 may be disposed to form a closed curve while surrounding the display area DPA in a plan view.

A width WFS of the second fusion pattern FSP2 may be smaller than a width of the sealing member 700 such that the second fusion pattern FSP2 is disposed inside the sealing member 700 along the sealing member 700 in a plan view. In the display device 10_1, since the second fusion pattern FSP2 is disposed along the sealing member 700 to form a closed curve, the adhesion between the display panel 100 and the encapsulation substrate 500 can be improved. In addition, since the second fusion pattern FSP2 further improves the bonding strength of the sealing member 700, the sealing member 700 can have a small width, and the non-display area NDA can be minimized.

However, the present disclosure according to the invention is not limited thereto, and the second fusion pattern FSP2 may also be disposed along the sealing member 700 but may be a plurality of patterns spaced apart from each other in another embodiment. In addition, in some embodiments, the second fusion pattern FSP2 may be formed at least along the corners of the sealing member 700. Since the sealing member 700 that bonds the display panel 100 and the encapsulation substrate 500 together has the second fusion pattern FSP2 formed each corner where the first extension portion and the second extension portion meet, durability can be further improved at each corner having relatively weak bonding strength.

As described above, the display panel 100 of the display device 10 includes first and second areas AA1 and AA2 determined according to whether the support members 900 are disposed. The support members 900 are disposed not to overlap light emitting elements EL or light emitting layers OL in a plan view and are disposed only in a certain type of pixels (e.g., first type pixels PXA) among different types of pixels PXA and PXB. According to an embodiment, not forming part of the claimed invention. each pixel PX of the display panel 100 may include an emission area EMA in which a light emitting element EL is disposed and a non-emission area NEA in which no light emitting element EL is disposed, and a support member 900 may be disposed in the non-emission area NEA of each pixel PX.

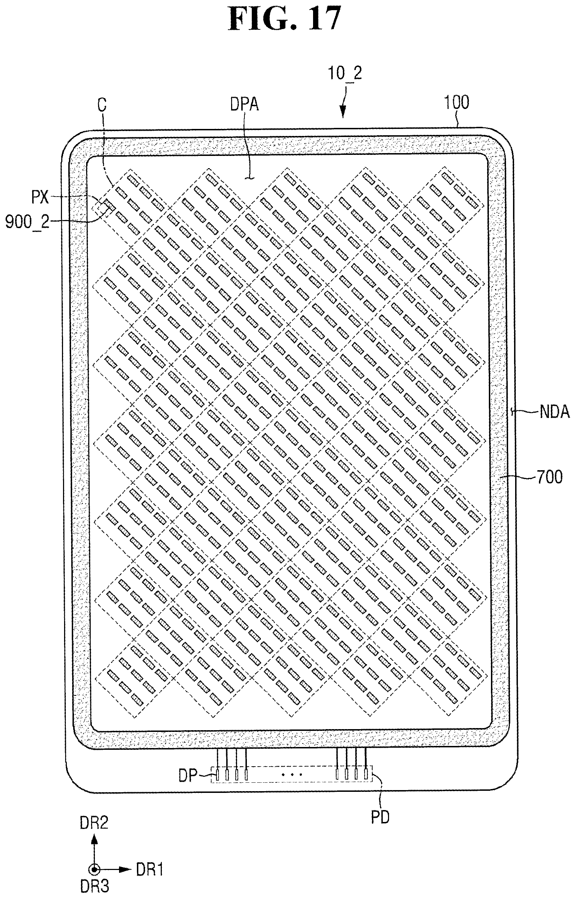

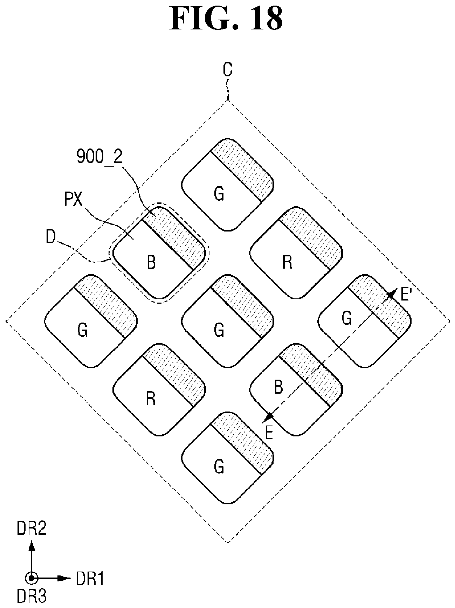

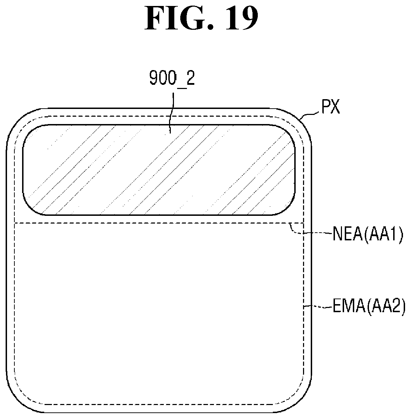

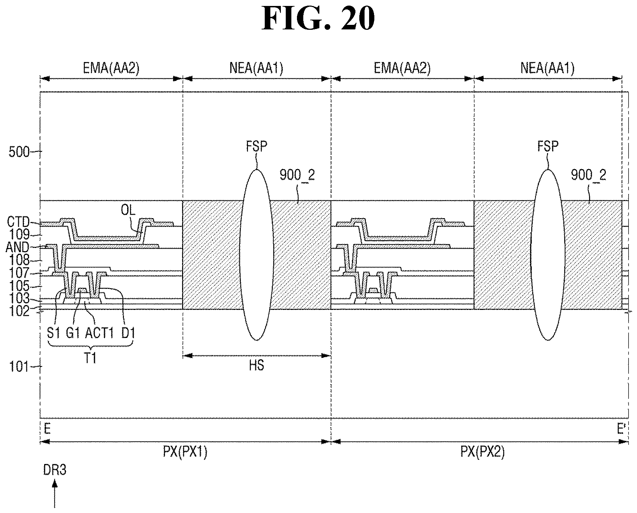

FIG. 17 is a plan view of support members 900_2 disposed on a display panel 100 according to an embodiment not forming part of the claimed invention. FIG. 18 is an enlarged view of portion C of FIG. 17. FIG. 19 is an enlarged view of portion D of FIG. 18. FIG. 20 is a cross-sectional view taken along line E-E' of FIG. 18. FIG. 20 illustrates a cross-section of two neighboring pixels PX.

Referring to FIGS. 17 through 20, each pixel PX of the display panel 100 of a display device 10_2 according to an embodiment, not forming part of the claimed invention, may include an emission area EMA and a non-emission area NEA, and a support member 900_2 may be disposed in the non-emission area NEA of each pixel PX. The display panel 100 of the display device 10_2 may include the same type of pixels (e.g., third type pixels), and each pixel PX may include the emission area EMA in which a light emitting element EL or a light emitting layer OL is disposed and the non-emission area NEA in which the light emitting element EL is not disposed but the support member 900_2 is disposed. In this case, the non-emission area NEA of each pixel PX may be a first area AA1 in which the support member 900_2 is disposed, and the emission area EMA may be a second area AA2. The display device 10_2 may include subpixels which emit light of different colors as the same type of pixels PX. The display device 10_2 may include first through third subpixels PX1 through PX3, each including the non-emission area NEA (i.e., the first area AA1) and the emission area EMA (i.e., the second area AA2). Each of the first through third subpixels PX1 through PX3 may include the light emitting element EL and the support member 900_2, but may be different in the type of the light emitting layer OL of the light emitting element EL. FIG. 20 illustrates a cross-section of a first subpixel PX1 and a second subpixel PX2.

The display panel 100 may include the same type of pixels (e.g., the third type pixels), and only the same type of pixels may be disposed in a unit pixel area (part C of FIG. 17). In addition, each pixel PX may include the support member 900_2, and a plurality of support members 900_2 may be arranged at regular intervals in a unit pixel area. The support member 900_2 may be disposed in the non-emission area NEA of each pixel PX, and at least one emission area EMA may be disposed between the support members 900_2.

As described above, a width of a fusion pattern FSP may be about 10 *µ*m, and a width of each pixel PX may be about 25 *µ*m. In some embodiments, the support member 900_2 may have a small width such that it can be included in each pixel PX, but the width of the support member 900_2 may be in a range that allows the fusion pattern FSP to be formed in the support member 900_2. In this case, each pixel PX may include an area where the light emitting element EL is disposed and an area where the support member 900_2 is disposed.

Each pixel PX may include the emission area EMA in which the light emitting element EL is disposed and from which light generated by the light emitting layer OL is emitted and the non-emission area NEA in which the light emitting element EL is not disposed. Circuit elements for driving the light emitting element EL may be disposed in at least a portion of the non-emission area NEA. The emission area EMA and the non-emission area NEA are areas defined according to the placement or position of the light emitting element EL or the light emitting layer OL and, in some cases, may be distinguished based on an opening of a pixel defining layer 109. That is, the emission area EMA may be an opening area in which the opening of the pixel defining layer 109 is disposed, and the non-emission area NEA may be a non-opening area in which the pixel defining layer 109 is disposed.

According to an embodiment, the support member 900_2 may be disposed in the non-emission area NEA of each pixel PX and may not overlap the light emitting element EL. In addition, the support member 900_2 may not overlap the circuit elements included in each pixel PX, for example, a plurality of wirings and transistors. The support member 900_2 may directly contact a base substrate 101 and an encapsulation substrate 500 as described above. The fusion pattern FSP may be disposed at least between the support member 900_2 and the encapsulation substrate 500 and, in some cases, may extend from the encapsulation substrate 500 to the base substrate 101. The shape and placement of the fusion pattern FSP are the same as those described above, and thus a detailed description thereof will be omitted.

Each pixel PX of the display device 10_2 according to the embodiment may include the first area AA1 in which the support member 900_2 is disposed and the second area AA2 in which the support member 900_2 is not disposed. In the display device 10_2, the support member 900_2 may be disposed in each pixel PX, and a greater number of the support members 900_2 and the fusion patterns FSP may be disposed over the entire display area DPA. Therefore, the display device 10_2 can further improve the adhesion between the display panel 100 and the encapsulation substrate, and the durability of the display device 10_2 against external impact can be further improved.

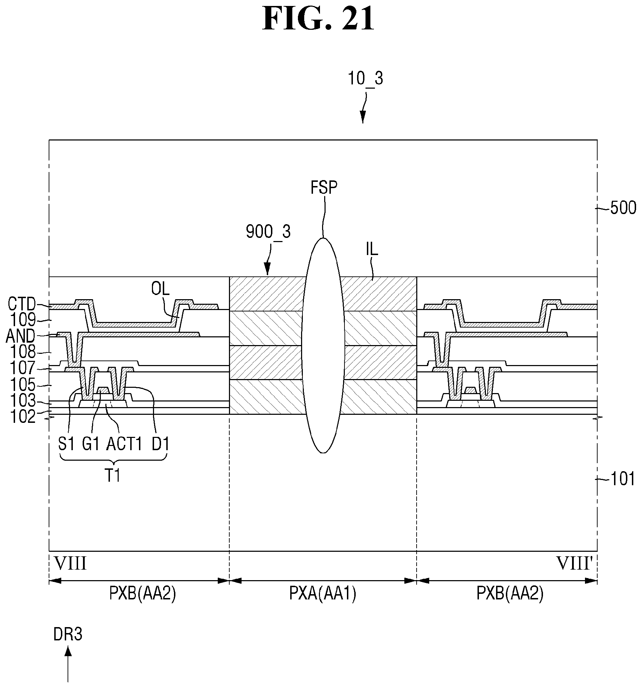

FIG. 21 is a schematic cross-sectional view of a portion of a display device 10_3 according to an embodiment.

Referring to FIG. 21, a support member 900_3 of the display device 10_3 may have a structure in which a plurality of layers is sequentially stacked. The support member 900_3 may be made of an inorganic insulating material or an organic insulating material. In some embodiments, the support member 900_3 may have a structure in which a plurality of insulating layers IL made of the inorganic insulating material or the organic insulating material are stacked. A fusion pattern FSP extending from a base substrate 101 to an encapsulation substrate 500 may be formed to pass through the insulating layers IL of the support member 900_3. In an exemplary embodiment, the support member 900_3 may be a multilayer in which layers including one or more inorganic materials selected from silicon oxide (SiOx), silicon nitride (SiNx) and silicon oxynitride (SiON) or an organic material such as photoresist (PR) or polyimide (PI) are alternately stacked. However, the present disclosure according to the invention is not limited thereto. The embodiment of FIG. 21 is different from the embodiment of FIG. 8 in that the support member 900_3 has a structure in which a plurality of insulating layers IL are stacked. Hereinafter, a redundant description will be omitted.

The fusion pattern FSP may have various shapes according to a laser focus FPL, intensity, etc. of a pulsed laser irradiated during a fabrication process of the display device 10_3. In the display device 10_3, the interfacial adhesion between the support member 900_3 or a sealing member 700 and the encapsulation substrate 500 may be somewhat weak, and the fusion pattern FSP may be selectively formed to reinforce the interfacial adhesion. According to some embodiments, in the display device 10_3, the fusion pattern FSP may be disposed only at an interface between the support member 900_3 and the encapsulation substrate 500 or a display panel 100.

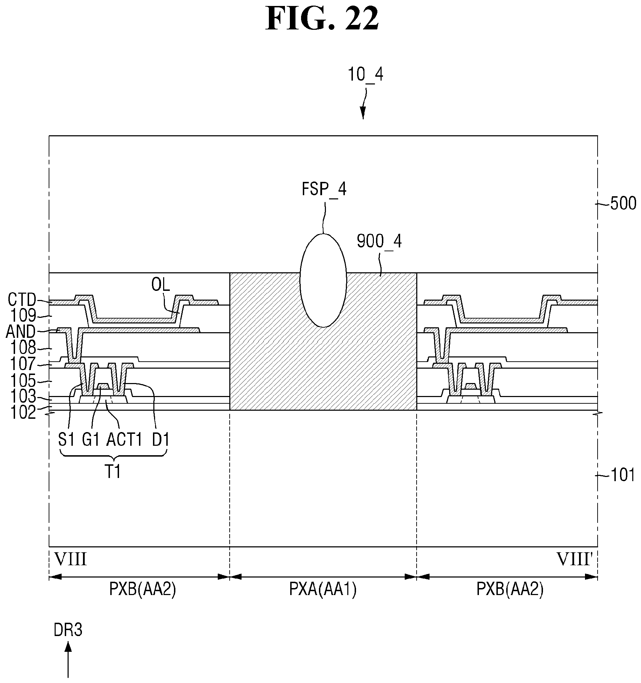

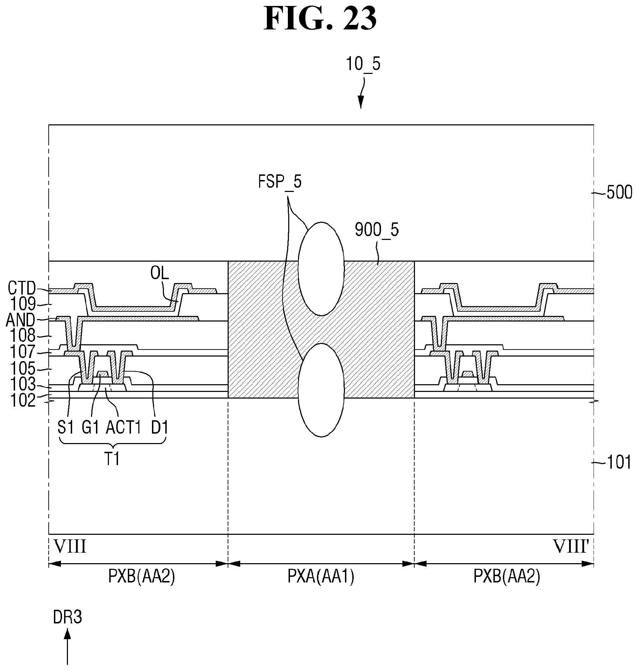

FIGS. 22 and 23 are schematic cross-sectional views illustrating parts of display devices 10_4 and 10_5 according to embodiments.

Referring to FIG. 22, in the display device 10_4 according to an embodiment, a fusion pattern FSP _4 is disposed over an interface between a support member 900_4 and an encapsulation substrate 500. The fusion pattern FSP_4 may be spaced apart from an upper surface of a display panel 100. While a physical boundary exists at an interface between a lower surface of the support member 900_4 and the upper surface of the display panel 100, an interface between an upper surface of the support member 900_4 and a lower surface of the encapsulation substrate 500 may include a portion where no physical interface exists due to the fusion pattern FSP_4 disposed at the interface. In this case, since the fusion pattern FSP_4 is formed by fusion of the support member 900_4 and the encapsulation substrate 500, it includes a mixture of materials that form them. The embodiment of FIG. 22 is different from the embodiment of FIG. 8 in that the fusion pattern FSP_4 is disposed only at the interface between the support member 900_4 and the encapsulation substrate 500. A redundant description will be omitted, and differences will be mainly described below.

During a fabrication process of the display device 10_4, when a laser focus FPL is set to be located inside the support member 900_4, the fusion pattern FSP_4 may be formed only in a portion of the support member 900_4 to which a laser is irradiated from the laser focus FPL. For example, when the laser focus FPL is set inside the support member 900_4 and a pulsed laser is irradiated from an upper surface of the encapsulation substrate 500, the fusion pattern FSP_4 may be formed only between the support member 900_4 and the encapsulation substrate 500. As described above, the interfacial adhesion between the encapsulation substrate 500 and the support member 900_4 or a sealing member 700 may be weak, and the display device 10_4 may be highly likely to have a defect between the encapsulation substrate 500 and the sealing member 700 due to external impact. To address this problem, the display device 10_4 according to the embodiment may further include the fusion pattern FSP_4. In particular, the fusion pattern FSP_4 may be disposed only at the interface between the encapsulation substrate 500 and the support member 900_4. Since the fusion pattern FSP _4 is formed through a process of irradiating a pulsed laser, when the laser focus FPL is set to be located inside the support member 900_4 and a laser is irradiated from the upper surface of the encapsulation substrate 500, circuit elements and light emitting elements EL included in the display panel 100 can be prevented from being damaged.

In addition, although not illustrated in the drawing, the display device 10_4 may further include a second fusion pattern FSP2 formed only at the interface between the sealing member 700 and the encapsulation substrate 500. In this case, since the second fusion pattern FSP2 is formed by fusion of the sealing member 700 and the encapsulation substrate 500, it may include a mixture of materials that form them. A lower surface of the sealing member 700 may form a physical boundary with the upper surface of the display panel 100 or a base substrate 101, and a portion of an upper surface of the sealing member 700 may not have a physical boundary with the encapsulation substrate 500 due to the second fusion pattern FSP2. This is the same as described above.

Referring to FIG. 23, in the display device 10_5 according to an embodiment, a fusion pattern FSP_5 may be formed only at a boundary between a support member 900_5 and an encapsulation substrate 500 and a boundary between the support member 900_5 and a display panel 100. The fusion patterns FSP_5 may be spaced apart from each other in the thickness direction (i.e., the third direction DR3) of the display device 10_5. The embodiment of FIG. 23 is different from the embodiment of FIG. 22 in that the fusion pattern FSP_5 is further formed at the boundary between the support member 900_5 and the display panel 100. Other redundant descriptions will be omitted.

A display device includes a display panel including a plurality of pixels and a plurality of support members disposed in a display area of the display panel. The support members are disposed in some of the pixels, or , in an example for forming part of the claimed invention, a support member is disposed in a portion of each pixel not to overlap a light emitting element in a plan view. The support members directly contact the display panel and an encapsulation substrate and may bond the display panel and the encapsulation substrate together with a sealing member that seals the display area.

In addition, a display device further includes a fusion pattern disposed across each support member. Thus, durability of the display device against external impact can be further improved.

## Claims

1. A display device (10) comprising:
a display panel (100) which comprises a base substrate (101) and a plurality of pixels (PX) disposed on the base substrate (101) in a display area;
an encapsulation substrate (500) which is disposed to face the display panel (100) at a distance from the display panel (100);
a plurality of support members (900) which is disposed between the base substrate (101) and the encapsulation substrate (500); and
a first fusion pattern (FSP1), at least a portion of which is disposed in each of the support members (900) and the encapsulation substrate (500), wherein the first fusion pattern (FSP1) includes a mixture of materials forming the support members (900) and the encapsulation substrate (500), wherein the pixels (PX) comprise first type pixels (PXA) in which the support members (900) are disposed and second type pixels (PXB) in which no support member (900) is disposed but light emitting elements (EL) and circuits elements for driving the light emitting elements (EL) are included
**characterized in that**
the first type pixels (PXA) do not include light emitting elements (EL), and
the support members (900) directly contact an upper surface of the base substrate (101) and a lower surface of the encapsulation substrate (500).

2. The display device (10) of claim 1, wherein each of the support members (900) comprises a first boundary surface (CS1) contacting the base substrate (101) and a second boundary surface (CS2) contacting the encapsulation substrate (500), and
no physical boundary exists in a virtual extension line in the first fusion pattern (FSP1), the virtual extension line extending from each of the first boundary surface (CS1) and the second boundary surface (CS2).

3. The display device (10) of at least one of claims 1 or 2, wherein the second type pixels (PXB) comprise a first subpixel (PXA) which emits light of a first color and a second subpixel (PXB) which emits light of a second color different from the first color.

4. The display device (10) of at least one of claims 1 to 3, wherein the display panel (100) comprises the display area (DPA) in which the pixels (PX) are disposed and a non-display area (NDA) which surrounds the display area (DPA), and further comprising a sealing member (700) which is disposed in the non-display area (NDA) to surround the display area (DPA) and bonds the encapsulation substrate (500) and the display panel (100) together.

5. The display device (10) of claim 4, further comprising a second fusion pattern (FSP2) which is disposed over the support member (900), the base substrate (101) and the encapsulation substrate (500), wherein the second fusion pattern (FSP2) surrounds the display area (DPA) to have a closed curve shape.

## Patentansprüche

1. Anzeigevorrichtung (10), die Folgendes umfasst:
ein Anzeigefeld (100), das ein Basissubstrat (101) und eine Vielzahl von Pixeln (PX) umfasst, die auf dem Basissubstrat (101) in einem Anzeigebereich angeordnet ist;
ein Verkapselungssubstrat (500), das dazu angeordnet ist, dem Anzeigefeld (100) in einem Abstand von dem Anzeigefeld (100) zugewandt zu sein;
eine Vielzahl von Stützgliedern (900), die zwischen dem Basissubstrat (101) und dem Verkapselungssubstrat (500) angeordnet ist; und
ein erstes Fusionsmuster (FSP1), von dem mindestens ein Abschnitt in jedem der Stützglieder (900) und dem Verkapselungssubstrat (500) angeordnet ist, wobei das erste Fusionsmuster (FSP1) eine Mischung von Materialien einschließt, die die Stützglieder (900) und das Verkapselungssubstrat (500) bilden, wobei die Pixel (PX) Pixel eines ersten Typus (PXA), in denen die Stützglieder (900) angeordnet sind, und Pixel eines zweiten Typus (PXB) umfassen, in denen kein Stützglied (900) angeordnet ist, doch lichtemittierende Elemente (EL) und Schaltungselemente, um die lichtemittierenden Elemente (EL) anzutreiben, eingeschlossen sind,
**dadurch gekennzeichnet, dass**
die Pixel des ersten Typus (PXA) keine lichtemittierenden Elemente (EL) einschließen und die Stützglieder (900) unmittelbar eine obere Oberfläche des Basissubstrats (101) und eine untere Oberfläche des Verkapselungssubstrats (500) kontaktieren.

2. Anzeigevorrichtung (10) nach Anspruch 1, wobei jedes der Stützglieder (900) eine erste Grenzfläche (CS1), die das Basissubstrat (101) kontaktiert, und eine zweite Grenzfläche (CS2), die das Verkapselungssubstrat (500) kontaktiert, umfasst und
keine physikalische Grenze in einer virtuellen Erstreckungslinie im ersten Fusionsmuster (FSP1) existiert, wobei sich die virtuelle Erstreckungslinie von jeder der ersten Grenzfläche (CS1) und der zweiten Grenzfläche (CS2) aus erstreckt.

3. Anzeigevorrichtung (10) nach mindestens einem der Ansprüche 1 oder 2, wobei die Pixel des zweiten Typus (PXB) einen ersten Unterpixel (PXA), der Licht einer ersten Farbe emittiert, und einen zweiten Unterpixel (PXB) umfassen, der Licht einer zweiten Farbe emittiert, die sich von der ersten Farbe unterscheidet.

4. Anzeigevorrichtung (10) nach mindestens einem der Ansprüche 1 bis 3, wobei das Anzeigefeld (100) den Anzeigebereich (DPA), in dem die Pixel (PX) angeordnet sind, und einen Nicht-Anzeigebereich (NDA), der den Anzeigebereich (DPA) umgibt, umfasst, und ferner ein Dichtungsglied (700) umfassend, das in dem Nicht-Anzeigebereich (NDA) angeordnet ist, um den Anzeigebereich (DPA) zu umgeben, und das Verkapselungssubstrat (500) und das Anzeigefeld (100) miteinander verbindet.

5. Anzeigevorrichtung (10) nach Anspruch 4, die ferner ein zweites Fusionsmuster (FSP2) umfasst, das über dem Stützglied (900), dem Basissubstrat (101) und dem Verkapselungssubstrat (500) angeordnet ist, wobei das zweite Fusionsmuster (FSP2) den Anzeigebereich (DPA) umgibt, um eine geschlossene Krümmungsform aufzuweisen.

## Revendications

1. Dispositif d'affichage (10) comprenant :
un panneau d'affichage (100) qui comprend un substrat de base (101) et une pluralité de pixels (PX) disposés sur le substrat de base (101) dans une zone d'affichage ;
un substrat d'encapsulation (500) qui est disposé pour faire face au panneau d'affichage (100) à distance du panneau d'affichage (100) ;
une pluralité d'organes de support (900) qui sont disposés entre le substrat de base (101) et le substrat d'encapsulation (500) ; et
un premier motif de fusion (FSP1), dont au moins une portion est disposée dans chacun des organes de support (900) et du substrat d'encapsulation (500), dans lequel le premier motif de fusion (FSP1) inclut un mélange de matériaux formant les organes de support (900) et le substrat d'encapsulation (500), dans lequel les pixels (PX) comprennent des pixels de premier type (PXA) dans lesquels les organes de support (900) sont disposés et des pixels de second type (PXB) dans lesquels aucun organe de support (900) n'est disposé, mais des éléments émetteurs de lumière (EL) et des éléments de circuits pour piloter les éléments émetteurs de lumière (EL) sont inclus
**caractérisé en ce que**
les pixels de premier type (PXA) n'incluent pas d'éléments émetteurs de lumière (EL), et
les organes de support (900) sont directement en contact avec une surface supérieure du substrat de base (101) et une surface inférieure du substrat d'encapsulation (500).

2. Dispositif d'affichage (10) selon la revendication 1, dans lequel chacun des organes de support (900) comprend une première surface limite (CS1) en contact avec le substrat de base (101) et une seconde surface limite (CS2) en contact avec le substrat d'encapsulation (500), et
aucune limite physique n'existe dans une ligne d'extension virtuelle dans le premier motif de fusion (FSP1), la ligne d'extension virtuelle s'étendant à partir de chacune de la première surface limite (CS1) et de la seconde surface limite (CS2).

3. Dispositif d'affichage (10) selon au moins l'une des revendications 1 ou 2, dans lequel les pixels de second type (PXB) comprennent un premier sous-pixel (PXA) qui émet une lumière d'une première couleur et un second sous-pixel (PXB) qui émet une lumière d'une seconde couleur différente de la première couleur.

4. Dispositif d'affichage (10) selon au moins l'une des revendications 1 à 3, dans lequel le panneau d'affichage (100) comprend la zone d'affichage (DPA) dans laquelle les pixels (PX) sont disposés et une zone de non-affichage (NDA) qui entoure la zone d'affichage (DPA), et comprenant en outre un organe de scellement (700) qui est disposé dans la zone de non-affichage (NDA) pour entourer la zone d'affichage (DPA) et lie le substrat d'encapsulation (500) et le panneau d'affichage (100) ensemble.

5. Dispositif d'affichage (10) selon la revendication 4, comprenant en outre un second motif de fusion (FSP2) disposé sur l'organe de support (900), le substrat de base (101) et le substrat d'encapsulation (500), dans lequel le second motif de fusion (FSP2) entoure la zone d'affichage (DPA) pour avoir une forme de courbe fermée.
